(19) Europäisches Patentamt
European Patent Office
Office européen des brevets

(11) **EP 1 300 938 B1**

(12) **EUROPEAN PATENT SPECIFICATION**

(45) Date of publication and mention
of the grant of the patent:
**02.01.2013 Bulletin 2013/01**

(51) Int Cl.:
***H03D 7/12*** *(2006.01)*

(21) Application number: **02078484.9**

(22) Date of filing: **18.10.1999**

(54) **System and method for frequency up-conversion**

System und Verfahren zur Aufwertsmischung

Système et procédé de transposition élévatrice de fréquence

(84) Designated Contracting States:
**AT BE CH CY DE DK ES FI FR GB GR IE IT LI LU MC NL PT SE**
Designated Extension States:
**AL LT LV MK RO SI**

(30) Priority: **21.10.1998 US 176154**
**21.10.1998 US 176022**
**16.04.1999 US 293580**
**16.04.1999 US 293095**
**16.04.1999 US 293342**

(43) Date of publication of application:
**09.04.2003 Bulletin 2003/15**

(62) Document number(s) of the earlier application(s) in
accordance with Art. 76 EPC:
**99954941.3 / 1 110 303**

(73) Proprietor: **Parkervision, Inc.**
**Jacksonville, FL 32256 (US)**

(72) Inventors:
• **Sorrels, David F.**
**Middleburgh, FL 32068 (US)**
• **Bultman, Michael J.**
**Jacksonville, FL 32246 (US)**
• **Cook, Robert W.**
**Switzerland, FL 32259 (US)**
• **Looke, Richard C.**
**Jacksonville, FL 32223 (US)**
• **Moses, Charley D. Jr.**
**Jacksonville, FL 32217 (US)**
• **Rawlins, Gregory S.**
**Heathrow, FL 32746 (US)**
• **Rawlins, Michael W.**
**Lake Mary, FL 32746-5917 (US)**

(74) Representative: **Cross, James Peter Archibald et al**
**R.G.C. Jenkins & Co**
**26 Caxton Street**
**London SW1H 0RJ (GB)**

(56) References cited:
**EP-A- 0 548 542      US-A- 4 130 765**
**US-A- 4 320 361      US-A- 4 967 160**
**US-A- 5 239 686      US-A- 5 557 641**

**Description**

*Field of the Invention*

The present invention is generally directed to frequency up-conversion of electromagnetic (EM) signals.

*Related Art*

Modem day communication systems employ components such as transmitters and receivers to transmit information from a source to a destination. To accomplish this transmission, information is imparted on a carrier signal and the carrier signal is then transmitted. Typically, the carrier signal is at a frequency higher than the baseband frequency of the information signal. Typical ways that the information is imparted on the carrier signal are called modulation.

Three widely used modulation schemes include: frequency modulation (FM), where the frequency of the carrier wave changes to reflect the information that has been modulated on the signal; phase modulation (PM), where the phase of the carrier signal changes to reflect the information imparted on it; and amplitude modulation (AM), where the amplitude of the carrier signal changes to reflect the information. Also, these modulation schemes are used in combination with each other (e.g., AM combined with FM and AM combined with PM).

For example, European Patent Application Publication No. 0 548 542 A1 (EP0548542) teaches a method and an apparatus for producing a periodic signal having a plurality of harmonics and isolating at least one harmonic of the plurality of harmonics. However, the method and apparatus of EP0548542 do not involve controlling a switch with an oscillating signal to cause the switch to gate a bias signal. Rather, in EP0548542 a varying signal is gated by the switch.

Additionally, U.S. Patent No. 4,320,361 (US4320361) teaches a method and an apparatus for modulating signal and filtering the signal to remove unwanted harmonics. However, the method and apparatus of US4320361 do not involve controlling a switch with an oscillating signal to cause the switch to gate a bias signal. Rather, in US4320361 a varying signal is gated by the switch.

*Summary of the Invention*

According to one aspect of the present invention, there is provided an apparatus according to claim 1.

According to another aspect of the present invention, there is provided a method according to claim 5.

The present invention is directed to methods and systems to up-convert a signal from a lower frequency to a higher frequency, and applications thereof.

In an embodiment, the present invention is used in a transmitter. The transmitter accepts an information signal at a baseband frequency and transmits a modulated signal at a frequency higher than the baseband frequency.

The information signal is used to modulate an oscillating signal to create a modulated intermediate signal. If needed, this modulated intermediate signal is "shaped" to provide a substantially optimum pulse-width-to-period ratio. According to the invention, this shaped signal is then used to control a switch which opens and closes as a function of the frequency and pulse width of the shaped signal. As a result of this opening and closing, a signal that is harmonically rich is produced with each harmonic of the harmonically rich signal being modulated substantially the same as the modulated intermediate signal. Through proper filtering, the desired harmonic (or harmonics) is selected and transmitted.

Further features and advantages of the invention, as well as the structure and operation of various embodiments of the invention, are described in detail below with reference to the accompanying figures.

*Brief Description of the Figures*

FIG. 1 illustrates a circuit for an in-phase/quadrature-phase modulation ("I/Q") transmitter;
FIGs. 2A, 2B, 2C, 2D, and 2E illustrate typical waveforms associated with the FIG. 1 "I/Q" circuit for digital information signal;
FIG. 3 illustrates the high level operational flowchart of a transmitter according to an embodiment of the present invention;
FIG. 4 illustrates the high level structural block diagram of the transmitter of an embodiment of the present invention;
FIG. 5 illustrates the operational flowchart of an embodiment of the present invention;
FIG. 6 illustrates an exemplary structural block diagram of the embodiment of the present invention;
FIG. 7 illustrates an implementation example of a local oscillator (LO);
FIG. 8 illustrates an implementation example of a phase shifter;
FIG. 9 illustrates an implementation example of a phase modulator;

FIGs. 10A-10C illustrate an implementation example of a switch module;

FIG. 11A-11C illustrate an example of the switch module of FIGs. 10A-10C wherein the switch is a GaAs FET;

FIGs. 12A-12C illustrate an example of a design to ensure symmetry for a GaAs FET implementation;

FIG. 13 illustrates an implementation example of a summer;

FIG. 14 illustrates an implementation example of a filter;

FIG. 15 is a representative spectrum demonstrating the calculation of "Q;"

FIGs. and 16B are representative examples of filter circuits;

FIG. 17 illustrates an implementation example of a transmission module;

FIG. 18A shows a first exemplary pulse shaping circuit using digital logic devices for a squarewave input from an oscillator;

FIGs. 18B, 18C, and 18D illustrate waveforms associated with the FIG. 18A circuit;

FIG. 19A shows a second exemplary pulse shaping circuit using digital logic devices for a squarewave input from an oscillator;

FIGs. 19B, 19C, and 19D illustrate waveforms associated with the FIG. 19A circuit;

FIG. 20 shows a third exemplary pulse shaping circuit for any input from an oscillator;

FIGs. 21A, 21B, 21C, 21D, and 21E illustrate representative waveforms associated with the FIG. 20 circuit;

FIG. 22 shows the internal circuitry for elements of FIG. 20 according to an embodiment of the invention;

FIG. 23 illustrates an implementation example of a harmonic enhancement module;

FIG. 24 illustrates an implementation example of an amplifier module;

FIGs. 25A and 25B illustrate exemplary circuits for a linear amplifier;

FIG. 26 is a table that illustrates the relative amplitudes of the first 50 harmonics for six exemplary pulse-width-to-period ratios;

## *Detailed Description of the Preferred Embodiments*

## *Table of Contents*

1. Terminology.

2. Overview of the Invention.

    2.1 In-phase/Quadrature-phase Modulation.

    2.2 Features of the Invention.

3. Frequency Up-conversion.

    3.1 High Level Description.

        3.1.2 Operational Description.
        3.1.2 Structural Description.

    3.2 In-phase/Quadrature-phase Modulation

        3.2.1 Operational Description.
        3.2.2 Structural Description.

    3.3 Methods and Systems for Implementing the Embodiments.

        3.3.1 The Local Oscillator.

            3.3.1.1 Operational Description.
            3.3.1.2 Structural Description.

        3.3.2 Shifter.

3.3.2.1 Operational Description.
3.3.2.2 Structural Description.

3.3.3 The Phase Modulator.

3.3.3.1 Operational Description.
3.3.3.2 Structural Description.

3.3.4 The Switch Module.

3.3.4.1 Operational Description.
3.3.4.2 Structural Description.

3.3.5 The Summer.

3.3.5.1 Operational Description.
3.3.5.2 Structural Description.

3.3.6 The Filter.

3.3.6.1 Operational Description.
3.3.6.2 Structural Description.

3.3.7 The Transmission Module.

3.3.7.1 Operational Description.
3.3.7.2 Structural Description.

3.3.8 Other Implementations.

4. Harmonic Enhancement.

4.1 High Level Description.

4.1.1 Operational Description.
4.1.2 Structural Description.

4.2 Exemplary Embodiments.

4.2.1 First Embodiment: When a Square Wave Feeds the Harmonic Enhancement Module to Create One Pulse per Cycle.

4.2.1.1 Operational Description.
4.2.1.2 Structural Description.

4.2.2 Second Embodiment: When a Square Wave Feeds the Harmonic Enhancement Module to Create Two Pulses per Cycle.

4.2.2.1 Operational Description.
4.2.2.2 Structural Description.

4.2.3 Third Embodiment: When Any Waveform Feeds the Harmonic Enhancement Module.

4.2.3.1 Operational Description.
4.2.3.2 Structural Description.

4.2.4 Other Embodiments.

4.3 Implementation Examples.

    4.3.1 First Digital Logic Circuit.
    4.3.2 Second Digital Logic Circuit.
    4.3.3 Analog Circuit.
    4.3.4 Other Implementations.

5. Amplifier Module.

5.1 High Level Description.

    5.1.1 Operational Description.
    5.1.2 Structural Description.

5.2 Exemplary Embodiment.

    5.2.1 Linear Amplifier.

        5.2.1.1 Operational Description.
        5.2.1.2 Structural Description.

    5.2.2 Other Embodiments.

5.3 Implementation Examples.

    5.3.1 Linear Amplifier.

        5.3.1.1 Operational Description.
        5.3.1.2 Structural Description.

    5.3.2 Other Implementations.

## *1. Terminology.*

Various terms used in this application are generally described in this section. Each description in this section is provided for illustrative and convenience purposes only, and is not limiting. The meaning of these terms will be apparent to persons skilled in the relevant art(s) based on the entirety of the teachings provided herein.

Analog signal: A signal in which the information contained therein is continuous as contrasted to discrete, and represents a time varying physical event or quantity. The information content is conveyed by varying at least one characteristic of the signal, such as but not limited to amplitude, frequency, or phase, or any combinations thereof.

Baseband signal: Any generic information signal desired for transmission and/or reception. As used herein, it refers to both the information signal that is generated at a source prior to any transmission (also referred to as the modulating baseband signal), and to the signal that is to be used by the recipient after transmission (also referred to as the demodulated baseband signal).

Carrier signal: A signal capable of carrying information. Typically, it is an electromagnetic signal that can be varied through a process called modulation. The frequency of the carrier signal is referred to as the carrier frequency. A communications system may have multiple carrier signals at different carrier frequencies.

Control a switch: Causing a switch to open and close. The switch may be, without limitation, mechanical, electrical, electronic, optical, etc., or any combination thereof. Typically, it is controlled by an electrical or electronic input. If the switch is controlled by an electronic signal, it is typically a different signal than the signals connected to either terminal of the switch.

Demodulated baseband signal: The baseband signal that is to be used by the recipient after transmission. Typically it has been down converted from a carrier signal and has been demodulated. The demodulated baseband signal should closely approximate the information signal (i.e., the modulating baseband signal) in frequency, amplitude, and information.

Demodulation: The process of removing information from a carrier or intermediate frequency signal.

Digital signal: A signal in which the information contained therein has discrete states as contrasted to a signal that has a property that may be continuously variable.

Direct down conversion: A down conversion technique wherein a received signal is directly down converted and demodulated, if applicable, from the original transmitted frequency (i.e., a carrier frequency) to baseband without having an intermediate frequency.

Down conversion: A process for performing frequency translation in which the final frequency is lower than the initial frequency.

Drive a switch: Same as control a switch.

Harmonic: A harmonic is a frequency or tone that, when compared to its fundamental or reference frequency or tone, is an integer multiple of it. In other words, if a periodic waveform has a fundamental frequency of "f" (also called the first harmonic), then its harmonics may be located at frequencies of "n•f," where "n" is 2, 3, 4, etc. The harmonic corresponding to n=2 is referred to as the second harmonic, the harmonic corresponding to n=3 is referred to as the third harmonic, and so on.

In-phase ("I") signal: The signal typically generated by an oscillator. It has not had its phase shifted and is often represented as a sine wave to distinguish it from a "Q" signal. The "I" signal can, itself, be modulated by any means. When the "I" signal is combined with a "Q" signal, the resultant signal is referred to as an "I/Q" signal.

In-phase/Quadrature-phase ("I/Q") signal: The signal that results when an "I" signal is summed with a "Q" signal. Typically, both the "I" and "Q" signals have been phase modulated, although other modulation techniques may also be used, such as amplitude modulation. An "I/Q" signal is used to transmit separate streams of information simultaneously on a single transmitted carrier. Note that the modulated "I" signal and the modulated "Q" signal are both carrier signals having the same frequency. When combined, the resultant "I/Q" signal is also a carrier signal at the same frequency.

Information signal: The signal that contains the information that is to be transmitted. As used herein, it refers to the original baseband signal at the source. When it is intended that the information signal modulate a carrier signal, it is also referred to as the "modulating baseband signal." It may be voice or data, analog or digital, or any other signal or combination thereof.

Intermediate frequency (IF) signal: A signal that is at a frequency between the frequency of the baseband signal and the frequency of the transmitted signal.

Modulation: The process of varying one or more physical characteristics of a signal to represent the information to be transmitted. Three commonly used modulation techniques are frequency modulation, phase modulation, and amplitude modulation. There are also variations, subsets, and combinations of these three techniques.

Operate a switch: Same as control a switch.

Quadrature-phase ("Q") signal: A signal that is out of phase with an in-phase ("I") signal. The amount of phase shift is predetermined for a particular application, but in a typical implementation, the "Q" signal is 90° out of phase with the "I" signal. Thus, if the "I" signal were a sine wave, the "Q" signal would be a cosine wave. When discussed together, the "I" signal and the "Q" signal have the same frequencies.

Spectrum: Spectrum is used to signify a continuous range of frequencies, usually wide, within which electromagnetic (EM) waves have some specific common characteristic. Such waves may be propagated in any communication medium, both natural and manmade, including but not limited to air, space, wire, cable, liquid, waveguide, microstrip, stripline, optical fiber, etc. The EM spectrum includes all frequencies greater than zero hertz.

Subharmonic: A subharmonic is a frequency or tone that is an integer submultiple of a referenced fundamental frequency or tone. That is, a subharmonic frequency is the quotient obtained by dividing the fundamental frequency by an integer. For example, if a periodic waveform has a frequency of "f" (also called the "fundamental frequency" or first subharmonic), then its subharmonics have frequencies of "f/n," where n is 2, 3, 4, etc. The subharmonic corresponding to n=2 is referred to as the second subharmonic, the subharmonic corresponding to n=3 is referred to as the third subharmonic, and so on. A subharmonic itself has possible harmonics, and the $i^{th}$ harmonic of the $i^{th}$ subharmonic will be at the fundamental frequency of the original periodic waveform. For example, the third subharmonic (which has a frequency of "f/3") may have harmonics at integer multiples of itself (i.e., a second harmonic at "2•f/3," a third harmonic at "3•f/3," and so on). The third harmonic of the third subharmonic of the original signal (i.e., "3•f/3") is at the frequency of the original signal.

Trigger a switch: Same as control a switch.

Up conversion: A process for performing frequency translation in which the final frequency is higher than the initial frequency.

### 2. Overview of the Invention.

The present invention is directed to systems and methods for frequency up-conversion, and applications thereof.

In one embodiment, the frequency up-converter is used as a system and method for transmitting an electromagnetic (EM) signal.

Based on the discussion contained herein, one skilled in the relevant art(s) will recognize that there are other, alternative embodiments in which the frequency up-converter of the present invention could be used in other applications, and that these alternative embodiments fall within the scope of the present invention.

Also for illustrative purposes, frequency up-conversion according to the present invention is described below in the context of a transmitter. However, the invention is not limited to this embodiment.

Additionally, for illustrative purposes only, the circuits and techniques described below all refer to the EM broadcast medium. However, the invention is not limited by this embodiment. Persons skilled in the relevant art(s) will recognize that these same circuits and techniques can be used in all transmission media (e.g., over-the-air broadcast, point-to-point cable, etc.).

### 2.1 In-phase/Quadrature-phase Modulation.

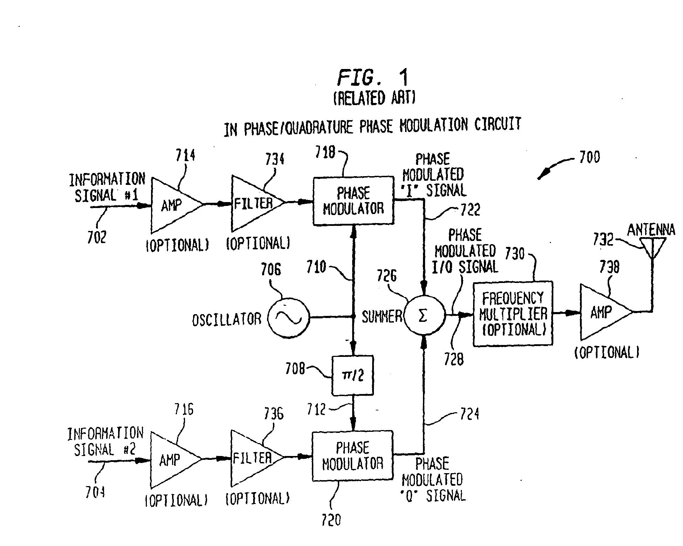

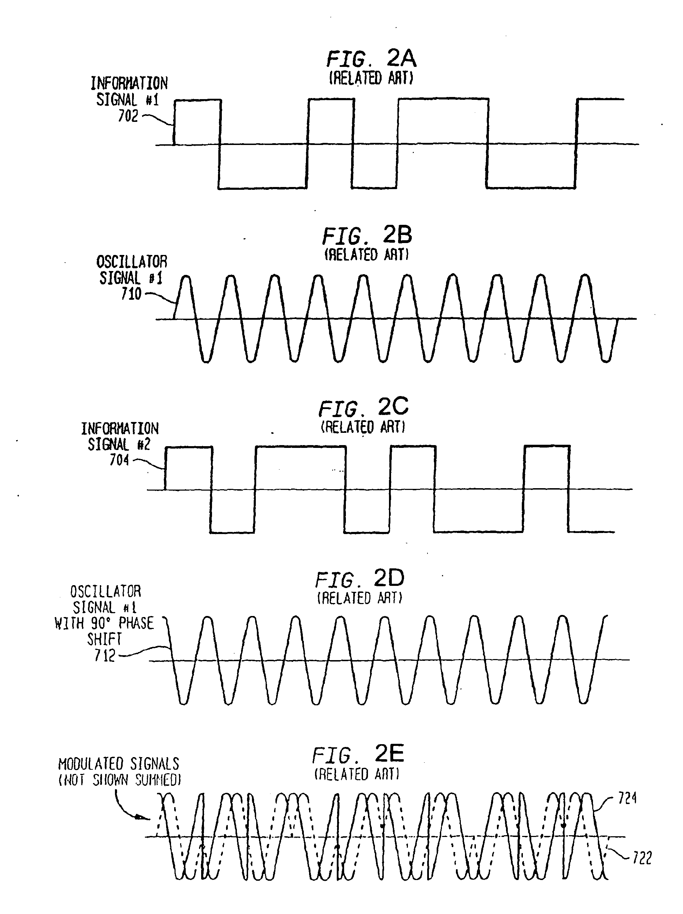

FIG. 1 illustrates an example of an in-phase/quadrature-phase ("I/Q") modulation circuit 700 and FIGs. 2A, 2B, 2C, 2D, and 2E illustrate examples of waveforms at several points in "I/Q" modulation circuit 700. In this technique, which increases bandwidth efficiency, separate information signals can be simultaneously transmitted on carrier signals that are out of phase with each other. That is, a first information signal 702 of FIG. 2A can be modulated onto the in-phase ("I") oscillator signal 710 of FIG. 2B and a second information signal 704 of FIG. 2C can be modulated onto the quadrature-phase ("Q") oscillator signal 712 of FIG. 2D. The "I" modulated signal is combined with the "Q" modulated signal and the resulting "I/Q" modulated signal is then transmitted. In a typical usage, both information signals are digital, and both are phase modulated onto the "I" and "Q" oscillating signals. One skilled in the relevant art(s) will recognize that the "I/Q" mode can also work with analog information signals, with combinations of analog and digital signals, with other modulation techniques, or any combinations thereof..

This "I/Q" modulation system uses two PM circuits together in order to increase the bandwidth efficiency. As stated above, in a PM circuit, the phase of an oscillating signal, such as 710 (or 712) (FIGs. 2B or 2D), is varied to represent the data to be communicated, such as an information signal such as 702 (or 704). For ease of understanding and display, the discussion herein will describe the more typical use of the "I/Q" mode, that is, with digital information signals and phase modulation on both oscillating signals. Thus, both signal streams are phase shift keying (PSK), which is a subset of PM.

"I/Q" modulation circuit 700 receives an information signal 702 from a first source (not shown) and an information signal 704 from a second source (not shown). Examples of information signals 702 and 704 are shown in FIG. 2A and 2C. Information signals 702 and 704 can be amplified by optional amplifiers 714 and 716 and filtered by optional filters 734 and 736. It is then routed to phase modulators 718 and 720. Also feeding phase modulators 718 and 720 are oscillating signals 710 and 712. Oscillating signal 710 was generated by a local oscillator 706, and is shown in FIG. 2B, and oscillating signal 712 is the phase shifted output of local oscillator 706. Local oscillators, such as local oscillator 706, output an electromagnetic wave at a predetermined frequency and amplitude.

The output of phase modulator 718 is a phase modulated signal 722 which is shown using a dotted line as one of the waveforms in FIG. 2E. Similarly, the output of phase modulator 720, which operates in a manner similar to phase modulator 718, is a phase modulated signal 724 which is shown using a solid line as the other waveform in FIG. 2E. The effect of phase modulators 718 and 720 on oscillating signals 710 and 712 is to cause them to change phase. As stated above, the system shown here is a PSK system, and as such, the phase of oscillating signals 710 and 712 is shifted by phase modulators 718 and 720 by a discrete amount as a function of information signals 702 and 704.

For simplicity of discussion and ease of display, oscillating signal 710 is shown on FIG. 2B as a sine wave and is referred to as the "I" signal in the "I/Q" circuit 700. After the output of oscillator 706 has gone through a phase shifter 708, shown here as shifting the phase by $-\pi/2$, oscillating signal 712 is a cosine wave, shown on FIG. 2D, and is referred to as the "Q" signal in the "I/Q" circuit. Again, for ease of display, phase modulators 718 and 720 are shown as shifting the phase of the respective oscillating signals 710 and 712 by 180°. This is seen on FIG. 2E. Modulated signal 722 is summed with modulated signal 724 by a summer 726. The output of summer 726 is the arithmetic sum of modulated signal 722 and 724 and is an "I/Q" signal 728. (For clarity of the display on FIG. 2E, the combined signal 728 is not shown. However, one skilled in the relevant art(s) will recognize that the arithmetic sum of 2 sinusoidal waves having the same frequency is also a sinusoidal wave at that frequency.)

"I/Q" signal 728 can then be routed to an optional frequency multiplier 730, where the frequency of "I/Q" signal 718 is increased from a relatively low level (e.g., 50 MHz to 100 MHz) to a higher level desired for broadcast (e.g., 900 MHz, 1.8 GHz), and to an optional amplifier 738 which increases the signal strength of "I/Q" signal 728 to a desired level for broadcast by an exemplary antenna 732.

### 2.2 Features of the Invention.

As apparent from the above, several frequencies are involved in a communications system. The frequency of the information signal is relatively low. The frequency of the local oscillator is higher than that of the information signal, but typically not high enough for efficient transmission. A third frequency, not specifically mentioned above, is the frequency of the transmitted signal which is greater than or equal to the frequency of the oscillating signal. This is the frequency that is routed from the optional frequency multipliers and optional amplifiers to the antennas in the previously described circuits.

Typically, in the transmitter subsystem of a communications system, upconverting the information signal to broadcast frequency requires, at least, filters, amplifiers, and frequency multipliers. Each of these components is costly, not only in terms of the purchase price of the component, but also because of the power required to operate them.

The present invention provides a more efficient means for producing a modulated carrier for transmission, uses less power, and requires fewer components. These and additional advantages of the present invention will be apparent from the following description.

### 3. Frequency Up-conversion.

The present invention is directed to systems and methods for frequency up-conversion and applications of the same. In one embodiment, the up-converter of the present invention is used in a transmitter. The invention is also directed to a transmitter. Based on the discussion contained herein, one skilled in the relevant art(s) will recognize that there are other, alternative embodiments and applications in which the frequency up-converter of the present invention could be used, and that these alternative embodiments and applications fall within the scope of the present invention.

For illustrative purposes, frequency up-conversion according to the present invention is described below in the context of a transmitter. However, as apparent from the preceding paragraph, the invention is not limited to this embodiment.

The following sections describe methods related to a transmitter and frequency up-converter. Structural exemplary embodiments for achieving these methods are also described. It should be understood that the invention is not limited to the particular embodiments described below.

### 3.1. High Level Description.

This section (including its subsections) provides a high-level description of up-converting and transmitting signals according to the present invention. In particular, an operational process of frequency up-conversion in the context of transmitting signals is described at a high-level. The operational process is often represented by flowcharts. The flowcharts are presented herein for illustrative purposes only, and are not limiting. In particular, the use of flowcharts should not be interpreted as limiting the invention to discrete or digital operation. In practice, those skilled in the relevant art(s) will appreciate, based on the teachings contained herein, that the invention can be achieved via discrete operation, continuous operation, or any combination thereof. Furthermore, the flow of control represented by the flowcharts is also provided for illustrative purposes only, and it will be appreciated by persons skilled in the relevant art(s) that other operational control flows are within the scope of the invention.

Also, a structural implementation for achieving this process is described at a high-level. This structural implementation is described herein for illustrative purposes, and is not limiting. In particular, the process described in this section can be achieved using any number of structural implementations, one of which is described in this section. The details of such structural implementations will be apparent to persons skilled in the relevant art(s) based on the teachings contained herein.

### 3.1.1 Operational Description.

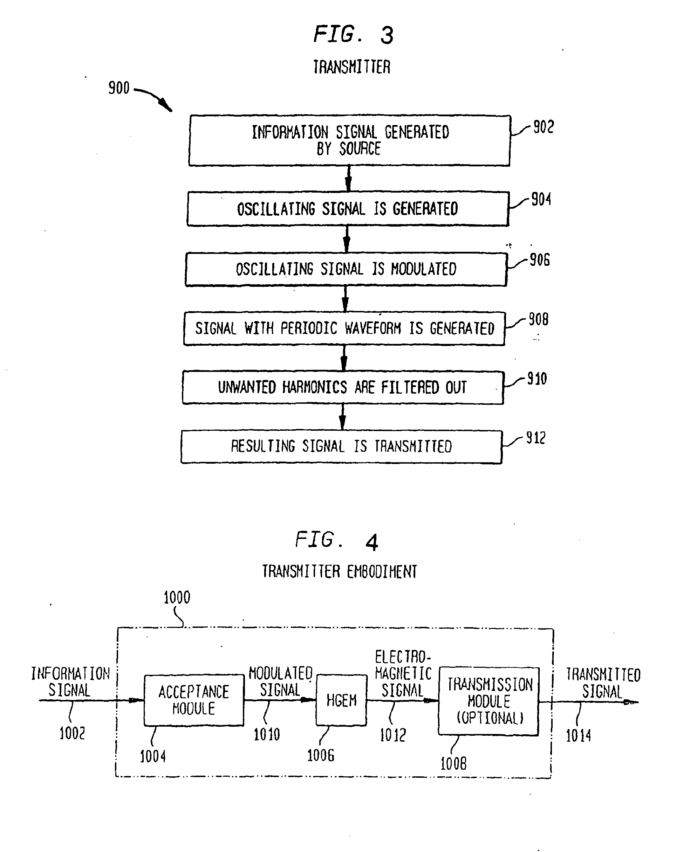

The flow chart 900 of FIG. 3 demonstrates the operational method of frequency up-conversion in the context of transmitting a signal according to an embodiment of the present invention. The invention is directed to both frequency up-conversion and transmitting signals as represented in FIG. 3.

In step 902, an information signal is generated by a source. This information signal may be analog, digital, and any combination thereof, or anything else that is desired to be transmitted, and is at the baseband frequency. As described below, the information signal is used to modulate an intermediate signal. Accordingly, the information signal is also herein called a modulating baseband information signal.

An oscillating signal 1904 is generated in step 904. In step 906, the oscillating signal is modulated, where the modulation is a result of, and a function of, the information signal. Step 906 produces a modulated oscillating signal, also called a modulated intermediate signal. As noted above, the flowchart of FIG. 3 is being described in the context of an example where the information signal is a digital signal. However, alternatively, the information signal can be analog or any combination of analog and digital. The remaining steps 908-912 of the flowchart of FIG. 3 operate in the same way, whether the information signal is digital, analog, etc., or any combination thereof, and regardless of what modulation technique is used.

A harmonically rich signal is generated from the modulated signal in step 908. The harmonically rich signal has a substantially continuous and periodically repeated waveform. In an embodiment, the waveform of the harmonically rich signal is substantially rectangular. One skilled in the relevant art(s) will recognize the physical limitations to and mathematical obstacles against achieving an exact or perfect rectangular waveform and it is not the intent or requirement of the present invention that a perfect rectangular waveform be generated or needed. However, for ease of discussion, the term "rectangular waveform" will be used herein and will refer to waveforms that are substantially rectangular, and will include but will not be limited to those waveforms that are generally referred to as square waves or pulses. It should be noted that if the situation arises wherein a perfect rectangular waveform is proven to be both technically and mathematically feasible, that situation will also fall within the scope of this invention.

A continuous periodic waveform is composed of a series of sinusoidal waves of specific amplitudes and phases, the frequencies of which are integer multiples of the repetition frequency of the waveform. (A waveform's repetition frequency is the number of times per second the periodic waveform repeats.) The information content of the harmonically rich signal can be obtained from any of its harmonics. As the harmonics have frequencies that are integer multiples of the repetition frequency of the harmonically rich signal, and since they have the same information content as the harmonically rich signal (as just stated), the harmonics each represent an up-converted representation of the harmonically rich signal. Some of the harmonics are at desired frequencies (such as the frequencies desired to be transmitted). These harmonics are called "desired harmonics" or "wanted harmonics." According to the invention, desired harmonics have sufficient amplitude for accomplishing the desired processing (i.e., being transmitted). Other harmonics are not at the desired frequencies. These harmonics are called "undesired harmonics" or "unwanted harmonics."

In step 910, any unwanted harmonics of the continuous periodic waveform of the harmonically rich signal are filtered out (for example, any harmonics that are not at frequencies desired to be transmitted). In step 912, the remaining harmonic is transmitted.

### 3.1.2 Structural Description.

FIG. 4 is a block diagram of an up-conversion system according to an embodiment of the invention. This embodiment of the up-conversion system is shown as a transmitter 1000. Transmitter 1000 includes an acceptance module 1004, a harmonic generation and extraction module 1006, and a transmission module 1008 that accepts an information signal 1002 and outputs a transmitted signal 1014.

Preferably, the acceptance module 1004, harmonic generation and extraction module 1006, and transmission module 1008 process the information signal in the manner shown in the operational flowchart 900. In other words, transmitter 1000 is the structural embodiment for performing the operational steps of flowchart 900. However, it should be understood that the scope of the present invention includes other structural embodiments for performing the steps of flowchart 900. The specifics of these other structural embodiments will be apparent to persons skilled in the relevant art(s) based on the discussion contained herein.

The operation of the transmitter 1000 will now be described in detail with reference to the flowchart 900. In step 902, an information signal 1002 from a source (not shown) is routed to acceptance module 1004. In step 904, an oscillating signal is generated and in step 906, it is modulated, thereby producing a modulated signal 1010. The oscillating signal can be modulated using any modulation technique, examples of which are described below. In step 908, the harmonic generation and extraction module (HGEM) generates a harmonically rich signal with a continuous and periodic waveform. This waveform is preferably a rectangular wave, such as a square wave or a pulse (although, the invention is not limited to this embodiment), and is comprised of a plurality of sinusoidal waves whose frequencies are integer multiples of the fundamental frequency of the waveform. These sinusoidal waves are referred to as the harmonics of the underlying waveform. A Fourier series analysis can be used to determine the amplitude of each harmonic. In step 910, a filter (not shown) within HGEM 1006 filters out the undesired frequencies (harmonics), and outputs an electromagnetic (EM) signal 1012 at the desired frequency. In step 912, EM signal 1012 is routed to transmission module 1008 (optional), where it is prepared for transmission. The transmission module 1008 then outputs a transmitted signal 1014.

### 3.2 In-phase/Quadrature-phase Modulation.

Various embodiments related to the method(s) and structure(s) described above are presented in this section (and its subsections). These embodiments are described herein for purposes of illustration, and not limitation. The invention is not limited to these embodiments. Alternative embodiments will be apparent to persons skilled in the relevant art(s) based on the teachings contained herein. The invention is intended and adapted to include such alternative embodiments.

Two information signals are accepted. An in-phase signal ("I") is modulated such that its phase varies as a function of one of the information signals, and a quadrature-phase signal ("Q") is modulated such that its phase varies as a function of the other information signal. The two modulated signals are combined to form an "I/Q" modulated signal and transmitted.

### 3.2.1 Operational Description.

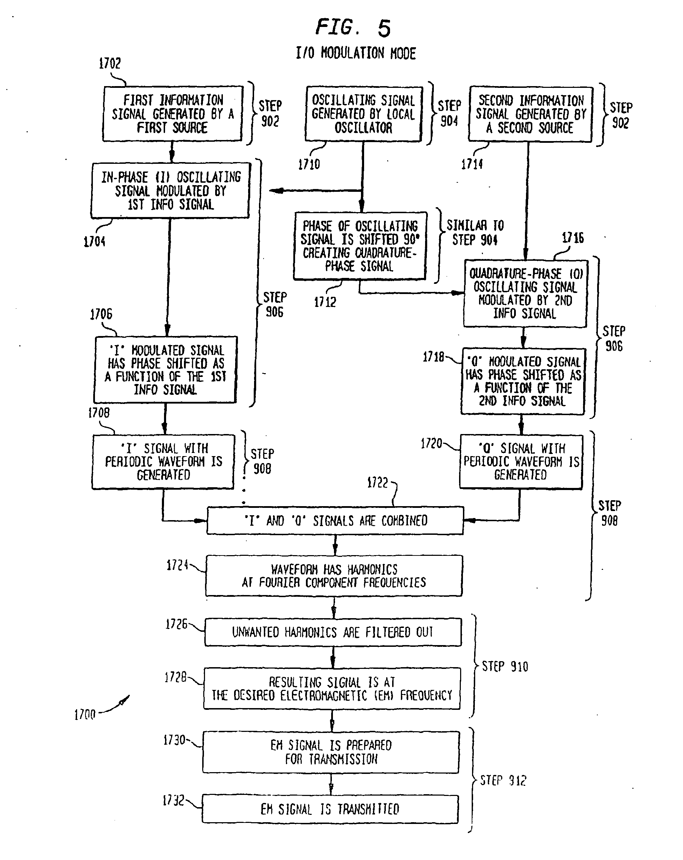

The flow chart of FIG. 5 demonstrates the method of operation of the transmitter in the in-phase/quadrature-phase modulation ("I/Q") mode. In step 1702, a first information signal is generated by a first source. This information signal may be analog, digital, or any combination thereof. In step 1710, an in-phase oscillating signal (referred to as the "I" signal) is generated and in step 1704, it is modulated by the first information signal. This results in the "I" modulated signal as indicated in block 1706 wherein the phase of the "I" modulated signal is varied as a function of the first information signal.

In step 1714, a second information signal is generated. Again, this signal may be analog, digital, or any combination thereof, and may be different than the first information signal. In step 1712, the phase of "I" oscillating signal generated in step 1710 is shifted, creating a quadrature-phase oscillating signal (referred to as the "Q" signal). In step 1716, the "Q" signal is modulated by the second information signal. This results in the "Q" modulated signal as indicated in block 1718 wherein the phase of the "Q" modulated signal is varied as a function of the second information signal.

An "I" signal with a continuous periodic waveform is generated at step 1708 using the "I" modulated signal, and a "Q" signal with a continuous periodic waveform is generated at step 1720 using the "Q" modulated signal. In step 1722, the "I" periodic waveform and the "Q" periodic waveform are combined forming what is referred to as the "I/Q" periodic waveform as indicated in block 1724. As stated before, a continuous and periodic waveform, such as a "I/Q" rectangular wave as indicated in block 1724, has sinusoidal components (harmonics) at frequencies that are integer multiples of the fundamental frequency of the underlying waveform (the Fourier component frequencies). In step 1726, the unwanted frequencies are removed, and as indicated in block 1728, the remaining frequency is at the desired EM output.

The "I/Q" EM signal is prepared for transmission in step 1730, and in step 1732, the "I/Q" EM signal is transmitted.

### 3.2.2 Structural Description.

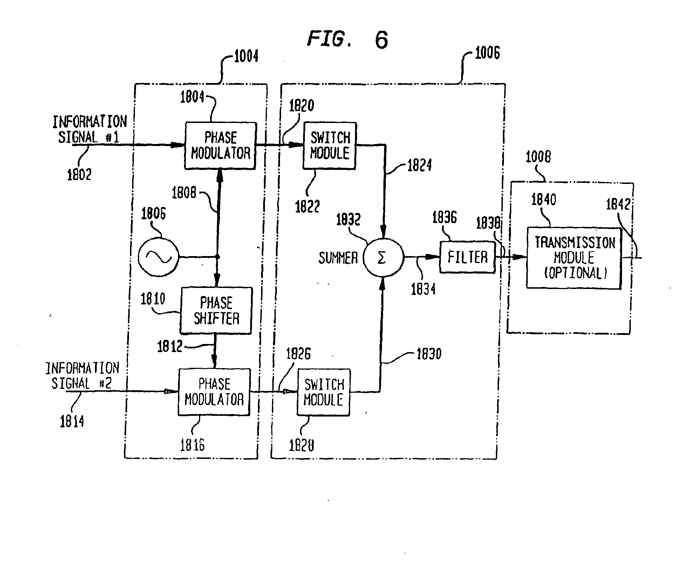

FIG. 6 is a block diagram of a transmitter according to an embodiment of the invention. This embodiment of the transmitter is shown as an "I/Q" transmitter 1800. "I/Q" transmitter 1800 includes a local oscillator 1806, a phase shifter 1810, two phase modulators 1804 & 1816, two switch modules 1822 & 1828, a summer 1832, a filter 1836, and a transmission module 1840. The "I/Q" transmitter accepts two information signals 1802 & 1814 and outputs a transmitted signal. The operation and structure of exemplary components are described below: an exemplary phase modulator is described below at sections 3.3.3-3.3.3.2; an exemplary local oscillator is described below at sections 3.3.1-3.3.1.2; an exemplary phase shifter is described below at sections 3.3.2-3.3.2.2; an exemplary switch module is described below at sections 3.3.4-3.3.4.2; an exemplary summer is described below at sections 3.3.5-3.3.5.2; an exemplary filter is described below at sections 3.3.6-3.3.6.2; and an exemplary transmission module is described below at sections 3.3.7-3.3.7.2.

Preferably, the local oscillator 1806, phase shifter 1810, phase modulators 1804 & 1816, switch modules 1822 & 1828, summer 1832, filter 1836, and transmission module 1840 process the information signal in the manner shown in the operational flowchart 1700. In other words, "I/Q" transmitter 1800 is the structural embodiment for performing the operational steps of flowchart 1700. However, it should be understood that the scope of the present invention includes other structural embodiments for performing the steps of flowchart 1700. The specifics of these other structural embodiments will be apparent to persons skilled in the relevant art(s) based on the discussion contained herein.

The operation of the transmitter 1800 will now be described in detail with reference to the flowchart 1700 In step 1702, a first information signal 1802 from a source (not shown) is routed to the first phase modulator 1804. In step 1710, an "I" oscillating signal 1808 from local oscillator 1806 is generated and in step 1704, "I" oscillating signal 1808 is modulated by first information signal 1802 in the first phase modulator 1804, thereby producing an "I" modulated signal 1820. In step 1708, the first switch module 1822 generates a harmonically rich "I" signal 1824 with a continuous and periodic waveform.

In step 1714, a second information signal 1814 from a source (not shown) is routed to the second phase modulator 1816. In step 1712, the phase of oscillating signal 1808 is shifted by phase shifter 1810 to create "Q" oscillating signal 1812. In step 1716, "Q" oscillating signal 1812 is modulated by second information signal 1814 in the second phase modulator 1816, thereby producing "Q" modulated signal 1826. In step 1720, the second switch module 1828 generates a harmonically rich "Q" signal 1830 with a continuous and periodic waveform. Harmonically rich "I" signal 1824 and harmonically rich "Q" signal 1830 are preferably rectangular waves, such as square waves or pulses (although, the invention is not limited to this embodiment), and are comprised of pluralities of sinusoidal waves whose frequencies are integer multiples of the fundamental frequency of the waveforms. These sinusoidal waves are referred to as the harmonics of the underlying waveforms, and a Fourier analysis will determine the amplitude of each harmonic.

In step 1722, harmonically rich "I" signal 1824 and harmonically rich "Q" signal 1830 are combined by summer 1832 to create harmonically rich "I/Q" signal 1834. In step 1726, a filter 1836 filters out the undesired harmonic frequencies, and outputs an "I/Q" electromagnetic (EM) signal 1838 at the desired harmonic frequency. In step 1730, "I/Q" EM signal 1838 is routed to transmission module 1840 (optional), where it is prepared for transmission. In step 1732, the transmission module 1840 outputs a transmitted signal 1842.

It will be apparent to those skilled in the relevant art(s) that an alternative embodiment exists wherein the harmonically rich "I" signal 1824 and the harmonically rich "Q" signal 1830 may be filtered before they are summed, and further, another alternative embodiment exists wherein "I" modulated signal 1820 and "Q" modulated signal 1826 may be summed to create an "I/Q" modulated signal before being routed to a switch module.

### 3.3 Methods and Systems for Implementing the Embodiments.

Exemplary operational and/or structural implementations related to the method(s), structure(s), and/or embodiments described above are presented in this section (and its subsections). These components and methods are presented herein for purposes of illustration, and not limitation. The invention is not limited to the particular examples of components and methods described herein. Alternatives will be apparent to persons skilled in the relevant art(s) based on the teachings contained herein. Such alternatives fall within the scope of the present invention.

### 3.3.1 The Local Oscillator.

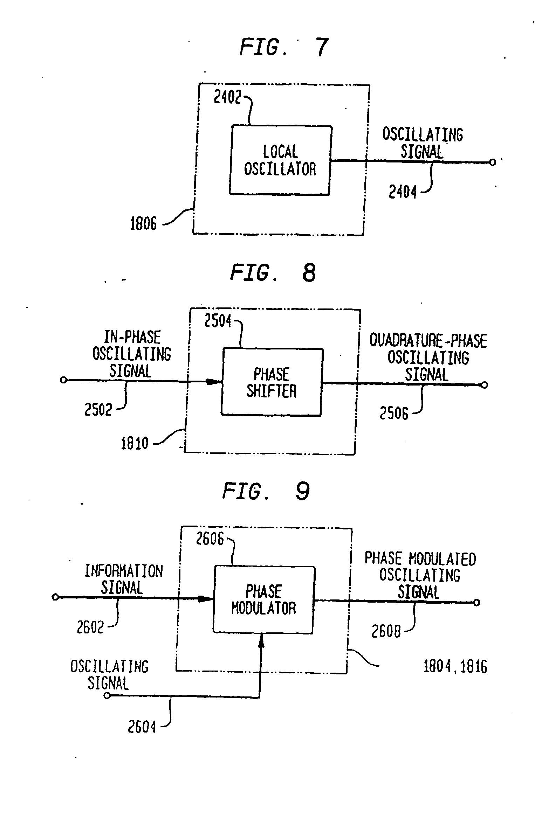

As discussed above, in-phase/quadrature-phase modulation ("I/Q") uses a local oscillator. See, as an example, local oscillator 1806 in FIG. 6. The invention supports numerous embodiments of the local oscillator. Exemplary embodiments of the local oscillator 2402 (FIG. 7) are described below. However, it should be understood that these examples are provided for illustrative purposes only. The invention is not limited to these embodiments.

### 3.3.1.1 Operational Description.

An oscillating signal 2404 is generated. The frequency of the signal 2404 may be selectable, but generally is not considered to be "variable." That is, the frequency may be selected to be a specific value for a specific implementation, but generally it does not vary as a function of the information signal (i.e., the modulating baseband signal).

The oscillating signal 2404 generally is a sinusoidal wave, but it may also be a rectangular wave, a triangular wave, a pulse, or any other continuous and periodic waveform. As stated above, one skilled in the relevant art(s) will recognize the physical limitations to and mathematical obstacles against achieving exact or perfect waveforms and it is not the intent of the present invention that a perfect waveform be generated or needed. Again, as stated above, for ease of discussion, the term "rectangular waveform" will be used to refer to waveforms that are substantially rectangular, the term "square wave" will refer to those waveforms that are substantially square, the term "triangular wave" will refer to those waveforms that are substantially triangular, and the term "pulse" will refer to those waveforms that are substantially a pulse, and it is not the intent of the present invention that a perfect square wave, triangle wave, or pulse be generated or needed.

### 3.3.1.2 Structural Description.

The design and use of a local oscillator 2402 is well known to those skilled in the relevant art(s). A local oscillator 2402 may be designed and fabricated from discrete components or it may be purchased "off the shelf." A local oscillator 2402 is generally set to output a specific frequency. The output can be "fixed" or it can be "selectable," based on the design of the circuit. If it is fixed, the output is considered to be substantially a fixed frequency that cannot be changed. If the output frequency is selectable, the design of the circuit will allow a control signal to be applied to the local oscillator 2402 to change the frequency for different applications. However, the output frequency of a local oscillator 2402 is not considered to be "variable" as a function of an information signal such as the modulating baseband signal. (If it were desired for the output frequency of an oscillator to be variable as a function of an information signal, a VCO would preferably be used.) The oscillating signal 2404 generally is a sinusoidal wave, but it may also be a rectangular wave, a triangular wave, a pulse, or any other continuous and periodic waveform.

The output of a local oscillator 2402 may be an input to other circuit components such as a phase modulator 2606, a phase shifting circuit 2504, etc.

### 3.3.2 The Phase Shifter.

As discussed above, in-phase/quadrature-phase modulation ("I/Q") uses a phase shifter. See, as an example, phase shifter 1810 in FIG. 6. The invention supports numerous embodiments of the phase shifter. Exemplary embodiments of the phase shifter 2504 (FIG. 8) are described below. The invention is not limited to these embodiments. The description contained herein is for a "90° phase shifter." The 90° phase shifter is used for ease of explanation, and one skilled in the relevant art(s) will understand that other phase shifts can be used without departing from the intent of the present invention.

### 3.3.2.1 Operational Description.

An "in-phase" oscillating signal 2502 is received and a "quadrature-phase" oscillating signal 2506 is output. If the in-phase ("I") signal 2502 is referred to as being a sine wave, then the quadrature-phase ("Q") signal 2506 can be referred to as being a cosine wave (i.e., the "Q" signal 2506 is 90° out of phase with the "I" signal 2502). However, they may also be rectangular waves, triangular waves, pulses, or any other continuous and periodic waveforms. As stated above, one skilled in the relevant art(s) will recognize the physical limitations to and mathematical obstacles against achieving exact or perfect waveforms and it is not the intent of the present invention that a perfect waveform be generated or needed. Again, as stated above, for ease of discussion, the term "rectangular waveform" will be used to refer to waveforms that are substantially rectangular, the term "square wave" will refer to those waveforms that are substantially square, the term "triangular wave" will refer to those waveforms that are substantially triangular, and the term "pulse" will refer to those waveforms that are substantially a pulse, and it is not the intent of the present invention that a perfect square wave, triangle wave, or pulse be generated or needed. Regardless of the shapes of the waveforms, the "Q" signal 2506 is out of phase with the "I" signal 2506 by one-quarter period of the waveform. The frequency of the "I" and "Q" signals 2502 and 2506 are substantially equal.

The discussion contained herein will be confined to the more prevalent embodiment wherein there are two intermediate signals separated by 90°. This is not limiting on the invention. It will be apparent to those skilled in the relevant art(s) that the techniques taught herein and applied to the "I/Q" embodiment of the present invention also apply to more exotic embodiments wherein the intermediate signals are shifted by some amount other than 90°, and also wherein there may be more than two intermediate frequencies.

### 3.3.2.2 Structural Description.

The design and use of a phase shifter 2504 is well known to those skilled in the relevant art(s). A phase shifter 2504 may be designed and fabricated from discrete components or it may be purchased "off the shelf." A phase shifter accepts an "in-phase" ("I") oscillating signal 2502 from any of a number of sources, such as a local oscillator 2402, and outputs a "quadrature-phase" ("Q") oscillating signal 2506 that is substantially the same frequency and substantially the same shape as the incoming "I" signal 2502, but with the phase shifted by 90°. Both the "I" and "Q" signals 2502 and 2506 are generally sinusoidal waves, but they may also be rectangular waves, triangular waves, pulses, or any other continuous and periodic waveforms. Regardless of the shapes of the waveforms, the "Q" signal 2506 is out of phase with the "I" signal 2502 by one-quarter period of the waveform. Both the "I" and "Q" signals 2502 and 2506 may be modulated.

The output of a phase shifter 2504 may be used as an input to a phase modulator 2606.

### 3.3.3 The Phase Modulator.

As discussed above, in-phase/quadrature-phase modulation ("I/Q") uses a phase modulator. See, as an example, phase modulators 1804 and 1816 of FIG. 6. The invention supports numerous embodiments of the phase modulator. Exemplary embodiments of the phase modulator 2606 (FIG. 9) are described below. However, it should be understood that these examples are provided for illustrative purposes only. The invention is not limited to these embodiments.

### 3.3.3.1 Operational Description.

An information signal 2602 and an oscillating signal 2604 are accepted, and a phase modulated oscillating signal 2608 whose phase varies as a function of the information signal 2602 is output. The information signal 2602 may be analog or digital and may be conditioned to ensure it is within the desired range. The oscillating signal 2604 can be a sinusoidal wave, a rectangular wave, a triangular wave, a pulse, or any other continuous and periodic waveform. As stated above, one skilled in the relevant art(s) will recognize the physical limitations to and mathematical obstacles against achieving exact or perfect waveforms and it is not the intent of the present invention that a perfect waveform be generated or needed. Again, as stated above, for ease of discussion, the term "rectangular waveform" will be used to refer to waveforms that are substantially rectangular, the term "square wave" will refer to those waveforms that are substantially square, the term "triangular wave" will refer to those waveforms that are substantially triangular, and the term "pulse" will refer to those waveforms that are substantially a pulse, and it is not the intent of the present invention that a perfect square wave, triangle wave, or pulse be generated or needed. The modulated oscillating signal 2608 is also referred to as the modulated intermediate signal 2608.

In the case where the information signal 2602 is digital, the modulated intermediate signal 2608 will shift phase between discrete values, the first phase (e.g., for a signal represented by sin $(\omega t+\theta_0)$) corresponding to a digital "high," and the second phase (e.g., for a signal represented by sin $(\omega t+\theta_0+\delta)$, where $\delta$ represents the amount the phase has been shifted) corresponding to a digital "low." Either phase may correspond to the "high" or the "low," depending on the convention being used. This operation is referred to as phase shift keying (PSK) which is a subset of PM.

If the information signal 2602 is analog, the phase of the modulated intermediate signal 2608 will vary as a function of the information signal 2602 and is not limited to the subset of PSK described above.

The modulated intermediate signal 2608 is a phase modulated signal which can be a sinusoidal wave, a rectangular wave, a triangular wave, a pulse, or any other continuous and periodic waveform, and which has substantially the same period as the oscillating signal 2604.

### 3.3.3.2 Structural Description.

The design and use of a phase modulator 2606 is well known to those skilled in the relevant art(s). A phase modulator 2606 may be designed and fabricated from discrete components, or it may be purchased "off the shelf." A phase modulator 2606 accepts an information signal 2602 from a source and an oscillating signal 2604 from a local oscillator 2402 or a phase shifter 2504. The information signal 2602 is at baseband and is generally an electrical signal within a prescribed voltage range. If the information is digital, the voltage will be at discrete levels. If the information is analog, the voltage will be continuously variable between an upper and a lower level as a function of the information signal 2602. The phase modulator 2606 uses the voltage of the information signal 2602 to modulate the oscillating signal 2604 and causes a modulated intermediate signal 2608 to be output. The information signal 2602, because it is a baseband signal and is used to modulate the oscillating signal, may be referred to as the modulating baseband signal 2604.

The modulated intermediate signal 2608 is an oscillating signal whose phase varies as a function of the voltage of the modulating baseband signal 2602. If the modulating baseband signal 2602 represents digital information, the phase of the modulated intermediate signal 2608 will shift by a discrete amount (e.g., the modulated intermediate signal 2608 will shift by an amount $\delta$ between sin $(\omega t+\theta_o)$ and sin $(\omega t+\theta_0+\delta)$). If, on the other hand, the modulating baseband signal 2602 represents analog information, the phase of the modulated intermediate signal 2608 will continuously shift between its higher and lower phase limits as a function of the information signal 2602. In one exemplary embodiment, the upper and lower limits of the modulated intermediate signal 2608 can be represented as sin$(\omega t+\theta_o)$ and sin$(\omega t+\theta_o+\pi)$. In other embodiments, the range of the phase shift may be less than n. The modulated intermediate signal 2608 can be a sinusoidal wave, a rectangular wave, a triangular wave, a pulse, or any other continuous and periodic waveform.

The phase modulated intermediate signal 2608 may then be used to drive a switch module 2802.

### 3.3.4 The Switch Module.

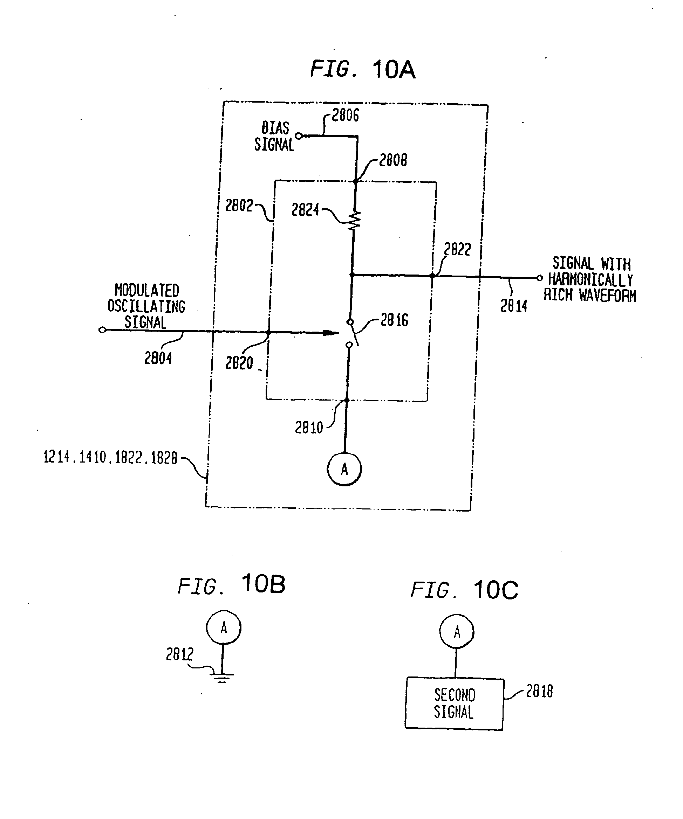

As discussed above, in-phase/quadrature-phase modulation ("I/Q") uses a switching assembly referred to as switch module 2802 (FIGs. 10A-10C). As an example, switch module 2802 is a component in switch modules 1822 and 1828 in FIG. 6. The invention supports numerous embodiments of the switch module. Exemplary embodiments of the switch module 2802 are described bellow. However, it should be understood that these examples are provided for illustrative purposes only. The invention is not limited to these embodiments.

### 3.3.4.1 Operational Description.

A bias signal 2806 is gated as a result of the application of a modulated oscillating signal 2804, and a signal with a harmonically rich waveform 2814 is created. The bias signal 2806 is generally a fixed voltage. The modulated oscillating signal 2804 can be frequency modulated, phase modulated, or any other modulation scheme or combination thereof. In certain embodiments, such as in certain amplitude shift keying modes, the modulated oscillating signal 2804 may also be amplitude modulated. The modulated oscillating signal 2804 can be a sinusoidal wave, a rectangular wave, a triangular wave, a pulse, or any other continuous and periodic waveform. In a preferred embodiment, modulated oscillating signal 2804 would be a rectangular wave. As stated above, one skilled in the relevant art(s) will recognize the physical limitations to and mathematical obstacles against achieving exact or perfect waveforms and it is not the intent of the present invention that a perfect waveform be generated or needed. Again, as stated above, for ease of discussion, the term "rectangular waveform" will be used to refer to waveforms that are substantially rectangular, the term "square wave" will refer to those waveforms that are substantially square, the term "triangular wave" will refer to those waveforms that are substantially triangular, and the term "pulse" will refer to those waveforms that are substantially a pulse, and it is not the intent of the present invention that a perfect square wave, triangle wave, or pulse be generated or needed.

The signal with harmonically rich waveform 2814, hereafter referred to as the harmonically rich signal 2814, is a continuous and periodic waveform that is modulated substantially the same as the modulated oscillating signal 2804. That is, if the modulated oscillating signal 2804 is frequency modulated, the harmonically rich signal 2814 will also be frequency modulated, and if the modulated oscillating signal 2804 is phase modulated, the harmonically rich signal 2814 will also be phase modulated. (In one embodiment, the harmonically rich signal 2814 is a substantially rectangular waveform.) As stated before, a continuous and periodic waveform, such as a rectangular wave, has sinusoidal components (harmonics) at frequencies that are integer multiples of the fundamental frequency of the underlying waveform (the Fourier component frequencies). Thus, the harmonically rich signal 2814 is composed of sinusoidal signals at frequencies that are integer multiples of the fundamental frequency of itself.

### 3.3.4.2 Structural Description.

The switch module 2802 of an embodiment of the present invention is comprised of a first input 2808, a second input 2810, a control input 2820, an output 2822, and a switch 2816. A bias signal 2806 is applied to the first input 2808 of the switch module 2802. Generally, the bias signal 2806 is a fixed voltage, and in one embodiment of the invention, a resistor 2824 is located between the bias signal 2806 and the switch 2816. The second input 2810 of the switch module 2802 is generally at electrical ground 2812. However, one skilled in the relevant art(s) will recognize that alternative embodiments exist wherein the second input 2810 may not be at electrical ground 2812, but rather a second signal 2818, provided that the second signal 2818 is different than the bias signal 2806.

A modulated oscillating signal 2804 is connected to the control input 2820 of the switch module 2802. The modulated oscillating signal 2804 may be frequency modulated or phase modulated. (In some circumstances and embodiments, it may be amplitude modulated, such as in on/off keying, but this is not the general case, and will not be described herein.) The modulated oscillating signal 2804 can be a sinusoidal wave, a rectangular wave, a triangular wave, a pulse, or any other continuous and periodic waveform. In a preferred embodiment, it would be a rectangular wave. The modulated oscillating signal 2804 causes the switch 2816 to close and open.

The harmonically rich signal 2814 described in section 3.3.4.1 above, is found at the output 2822 of the switch module 2802. The harmonically rich signal 2814 is a continuous and periodic waveform that is modulated substantially the same as the modulated oscillating signal 2804. That is, if the modulated oscillating signal 2804 is frequency modulated, the harmonically rich signal 2814 will also be frequency modulated, and if the modulated oscillating signal 2804 is phase modulated, the harmonically rich signal 2814 will also be phase modulated. In one embodiment, the harmonically rich signal 2814 has a substantially rectangular waveform. As stated before, a continuous and periodic waveform, such as a rectangular wave, has sinusoidal components (harmonics) at frequencies that are integer multiples of the fundamental frequency of the underlying waveform (the Fourier component frequencies). Thus, the harmonically rich signal 2814 is composed of sinusoidal signals at frequencies that are integer multiples of the fundamental frequency of itself. Each of these sinusoidal signals is also modulated substantially the same as the continuous and periodic waveform (i.e., the modulated oscillating signal 2804) from which it is derived.

The switch module 2802 operates as follows. When the switch 2816 is "open," the output 2822 of switch module 2802 is at substantially the same voltage level as bias signal 2806. Thus, since the harmonically rich signal 2814 is connected directly to the output 2822 of switch module 2802, the amplitude of harmonically rich signal 2814 is equal to the amplitude of the bias signal 2806. When the modulated oscillating signal 2804 causes the switch 2816 to become "closed," the output 2822 of switch module 2802 becomes connected electrically to the second input 2810 of switch module 2802 (e.g., ground 2812 in one embodiment of the invention), and the amplitude of the harmonically rich signal 2814 becomes equal to the potential present at the second input 2810 (e.g., zero volts for the embodiment wherein the second input 2810 is connected to electrical ground 2812). When the modulated oscillating signal 2804 causes the switch 2816 to again become "open," the amplitude of the harmonically rich signal 2814 again becomes equal to the bias signal 2806. Thus, the amplitude of the harmonically rich signal 2814 is at either of two signal levels, i.e., bias signal 2806 or ground 2812, and has a frequency that is substantially equal to the frequency of the modulated oscillating signal 2804 that causes the switch 2816 to open and close. The harmonically rich signal 2814 is modulated substantially the same as the modulated oscillating signal 2804. One skilled in the relevant art(s) will recognize that any one of a number of switch designs will fulfill the scope of the present invention as described herein.

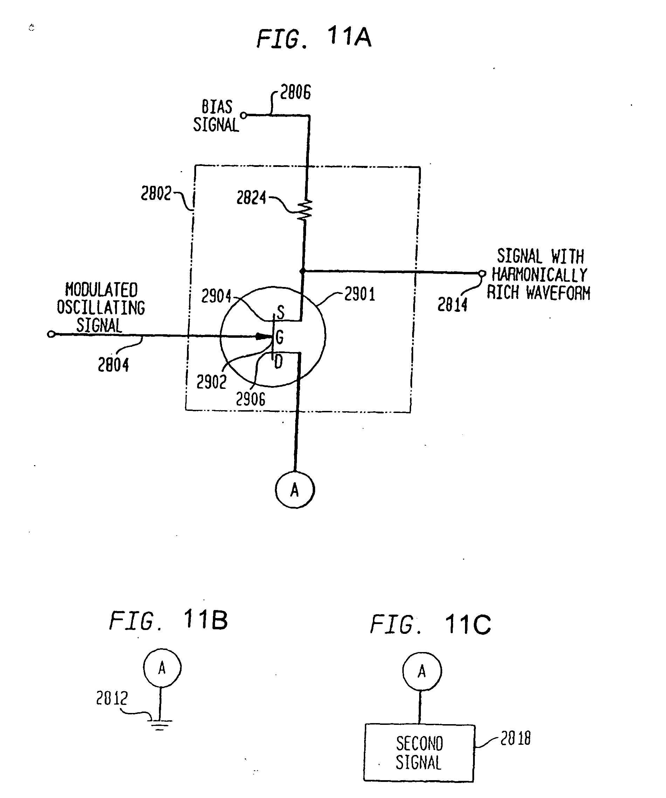

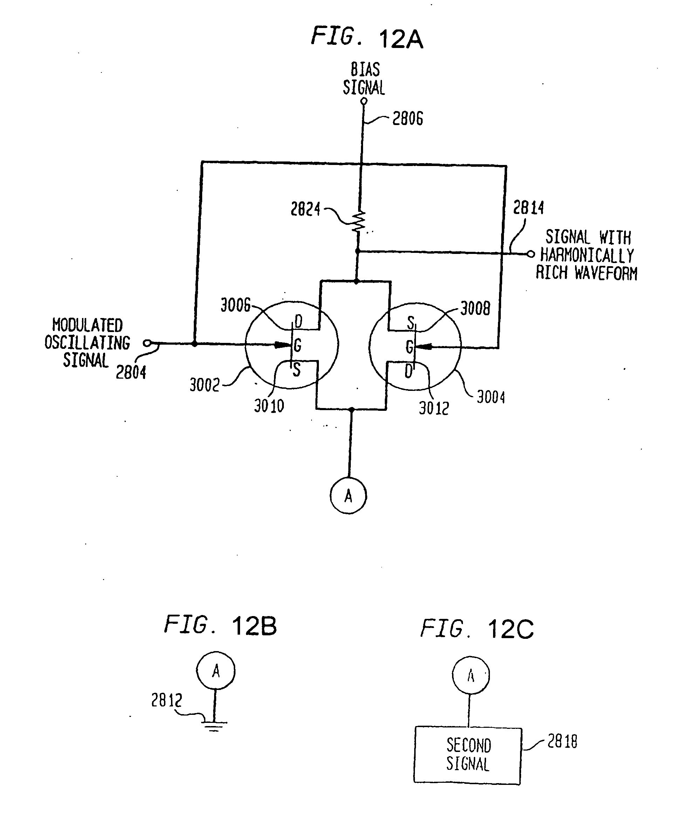

In an embodiment of the invention, the switch 2816 is a semiconductor device, such as a diode ring. In another embodiment, the switch is a transistor, such as a field effect transistor (FET). In an embodiment wherein the FET is gallium arsenide (GaAs), switch module 2802 can be designed as seen in FIGs. 11A-11C, where the modulated oscillating signal 2804 is connected to the gate 2902 of the GaAs FET 2901, the bias signal 2806 is connected through a bias resistor 2824 to the source 2904 of the GaAs FET 2901, and electrical ground 2812 is connected to the drain 2906 of GaAs FET 2901. (In an alternative embodiment shown in FIG. 11C, a second signal 2818 may be connected to the drain 2906 of GaAs FET 2901.) Since the drain and the source of GaAs FETs are interchangeable, the bias signal 2806 can be applied to either the source 2904 or to the drain 2906. If there is concern that there might be some source-drain asymmetry in the GaAs FET, the switch module can be designed as shown in FIGs. 12A-12C, wherein two GaAs FETs 3002 and 3004 are connected together, with the source 3010 of the first 3002 GaAs FET connected to the drain 3012 of the second 3004 GaAs FET, and the drain 3006 of the first 3002 GaAs FET being connected to the source 3008 of the second 3004 GaAs FET. This design arrangement will balance substantially all asymmetries.

An alternative implementation of the design includes a "dwell capacitor" wherein one side of a capacitor is connected to the first input of the switch and the other side of the capacitor is connected to the second input of the switch. The purpose of the design is to increase the apparent aperture of the pulse without actually increasing its width. Other switch designs and implementations will be apparent to persons skilled in the relevant art(s).

The output 2822 of the switch module 2802, i.e., the harmonically rich signal 2814, can be routed to a Summer 3402.

### 3.3.5 The Summer.

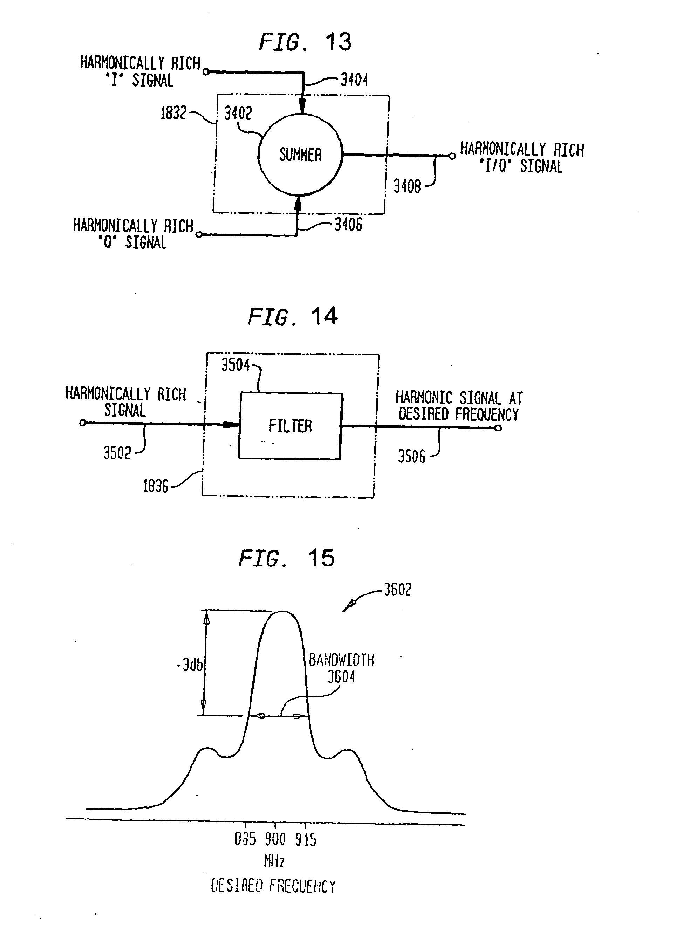

As discussed above, in-phase/quadrature-phase modulation ("I/Q") uses a summer. See, as an example, summer 1832 in FIG. 6. The invention supports numerous embodiments of the summer. Exemplary embodiments of the summer 3402 (FIG. 13) are described below. However, it should be understood that these examples are provided for illustrative purposes only. The invention is not limited to these embodiments.

### 3.3.5.1 Operational Description.

An "I" modulated signal 3404 and a "Q" modulated signal 3406 are combined and an "I/Q" modulated signal 3408 is generated. Generally, both "I" and "Q" modulated signals 3404 and 3406 are harmonically rich waveforms, which are referred to as the harmonically rich "I" signal 3404 and the harmonically rich "Q" signal 3406. Similarly, "I/Q" modulated signal 3408 is harmonically rich and is referred to as the harmonically rich "I/Q" signal. In one embodiment, these harmonically rich signals have substantially rectangular waveforms. As stated above, one skilled in the relevant art(s) will recognize the physical limitations to and mathematical obstacles against achieving exact or perfect waveforms and it is not the intent of the present invention that a perfect waveform be generated or needed.

In a typical embodiment, the harmonically rich "I" signal 3404 and the harmonically rich "Q" signal 3406 are phase modulated, as is the harmonically rich "I/Q" signal 3408. A person skilled in the relevant art(s) will recognize that other modulation techniques, such as amplitude modulating the "I/Q" signal, may also be used in the "I/Q" mode without deviating from the scope of the invention.

As stated before, a continuous and periodic waveform, such as harmonically rich "I/Q" signal 3408, has sinusoidal components (harmonics) at frequencies that are integer multiples of the fundamental frequency of the underlying waveform (the Fourier component frequencies). Thus, harmonically rich "I/Q" signal 3408 is composed of sinusoidal signals at frequencies that are integer multiples of the fundamental frequency of itself. These sinusoidal signals are also modulated substantially the same as the continuous and periodic waveform from which they are derived. That is, in this embodiment, the sinusoidal signals are phase modulated, and include the information from both the "I" modulated signal and the "Q" modulated signal.

### 3.3.5.2 Structural Description.

The design and use of a summer 3402 is well known to those skilled in the relevant art(s). A summer 3402 may be designed and fabricated from discrete components, or it may be purchased "off the shelf." A summer 3402 accepts a harmonically rich "I" signal 3404 and a harmonically rich "Q" signal 3406, and combines them to create a harmonically rich "I/Q" signal 3408. In a preferred embodiment of the invention, the harmonically rich "I" signal 3404 and the harmonically rich "Q" signal 3406 are both phase modulated. When the harmonically rich "I" signal 3404 and the harmonically rich "Q" signal 3406 are both phase modulated, the harmonically rich "I/Q" signal 3408 is also phase modulated.

As stated before, a continuous and periodic waveform, such as the harmonically rich "I/Q" signal 3408, has sinusoidal components (harmonics) at frequencies that are integer multiples of the fundamental frequency of the underlying waveform (the Fourier component frequencies). Thus, the harmonically rich "I/Q" signal 3408 is composed of "I/Q" sinusoidal signals at frequencies that are integer multiples of the fundamental frequency of itself. These "I/Q" sinusoidal signals are also phase modulated substantially the same as the continuous and periodic waveform from which they are derived (i.e., the harmonically rich "I/Q" signal 3408).

The output of the summer 3402 is then routed to a filter 3504.

### 3.3.6 The Filter.

As discussed above, in-phase/quadrature-phase modulation ("I/Q") uses a filter. See, as an example, filter 1836 in FIG. 6. The invention supports numerous embodiments of the filter. Exemplary embodiments of the filter 3504 (FIG. 14) are described below. However, it should be understood that these examples are provided for illustrative purposes only. The invention is not limited to these embodiments.

### 3.3.6.1 Operational Description.

A modulated signal with a harmonically rich waveform 3502 is accepted. It is referred to as the harmonically rich signal 3502. As stated above, a continuous and periodic waveform, such as the harmonically rich signal 3502, is comprised of sinusoidal components (harmonics) at frequencies that are integer multiples of the fundamental frequency of the underlying waveform from which they are derived. These are called the Fourier component frequencies. In one embodiment of the invention, the undesired harmonic frequencies are removed, and the desired frequency 3506 is output. In an alternative embodiment, a plurality of harmonic frequencies are output.

The harmonic components of the harmonically rich signal 3502 are modulated in the same manner as the harmonically rich signal 3502 itself.

### 3.3.6.2 Structural Description.

The design and use of a filter 3504 is well known to those skilled in the relevant art(s). A filter 3504 may be designed and fabricated from discrete components or it may be purchased "off the shelf." The filter 3504 accepts the harmonically rich signal 3502 from the summer 3402. The harmonically rich signal 3502 is a continuous and periodic waveform. As such, it is comprised of sinusoidal components (harmonics) that are at frequencies that are integer multiples of the fundamental frequency of the underlying harmonically rich signal 3502. The filter 3504 removes those sinusoidal signals having undesired frequencies. The signal 3506 that remains is at the desired frequency, and is called the desired output signal 3506.

To achieve this result, according to an embodiment of the invention, a filter 3504 is required to filter out the unwanted harmonics of the harmonically rich signal 3502.

The term "Q" is used to represent the ratio of the center frequency of the desired output signal 3506 to the half power band width. Looking at FIG. 15 we see a desired frequency 3602 of 900 MHz. The filter 3504 is used to ensure that only the energy at that frequency 3602 is transmitted. Thus, the bandwidth 3604 at half power (the so-called "3 dB down" point) should be as narrow as possible. The ratio of frequency 3602 to bandwidth 3604 is defined as "Q." As shown on FIG. 15, if the "3 dB down" point is at plus or minus 15 MHz, the value of Q will be $900 \div (15+15)$ or 30. With the proper selection of elements for any particular frequency, Qs on the order of 20 or 30 are achievable.

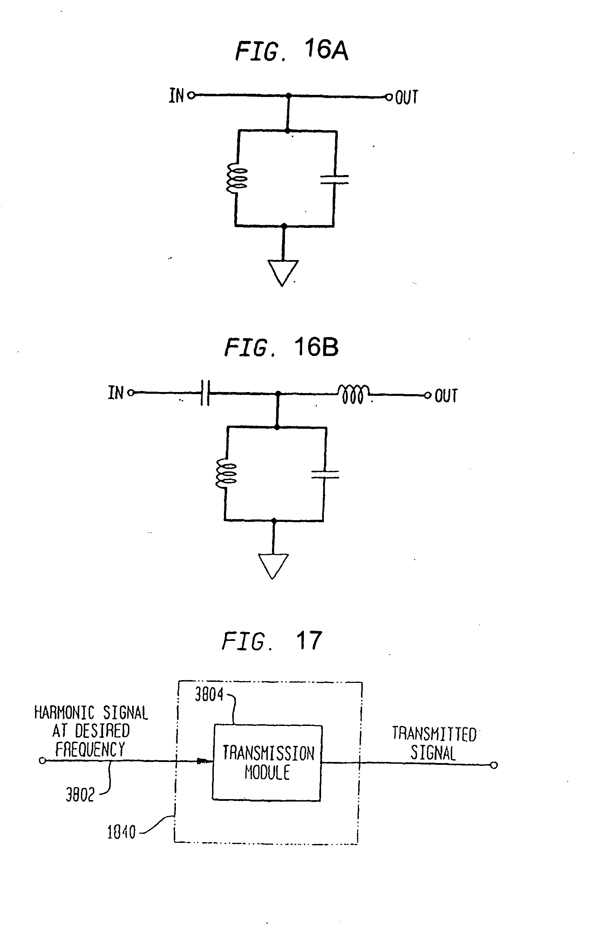

For crisp broadcast frequencies, it is desired that Q be as high as possible and practical, based on the given application and environment. The purpose of the filter 3504 is to filter out the unwanted harmonics of the harmonically rich signal. The circuits are tuned to eliminate all other harmonics except for the desired frequency 3506 (e.g., the 900 MHz harmonic 3602). Turning now to FIGs. 16A and 16B, we see examples of filter circuits. One skilled in the relevant art(s) will recognize that a number of filter designs will accomplish the desired goal of passing the desired frequency while filtering the undesired frequencies.

FIG. 16A illustrates a circuit having a capacitor in parallel with an inductor and shunted to ground. In FIG. 16B, a capacitor is in series with an inductor, and a parallel circuit similar to that in FIG. 16A is connected between the capacitor and inductor and shunted to ground.

The modulated signal at the desired frequency 3506 may then be routed to the transmission module 3804.

### 3.3.7 The Transmission Module.

As discussed above, in-phase/quadrature-phase modulation ("I/Q") uses a transmission module. See, as an example, transmission module 1840 in FIG. 6. The transmission module is optional, and other embodiments may not include a transmission module. The invention supports numerous embodiments of the transmission module. Exemplary embodiments of the transmission module 3804 (FIG. 17) are described below. However, it should be understood that these examples are provided for illustrative purposes only. The invention is not limited to these embodiments.

### 3.3.7.1 Operational Description.

A modulated signal at the desired frequency 3802 is accepted and is transmitted over the desired medium, such as, but not limited to, over-the-air broadcast or point-to-point cable.

### 3.3. 7.2 Structural Description.

The transmission module 3804 receives the signal at the desired EM frequency 3802. If it is intended to be broadcast over the air, the signal may be routed through an optional antenna interface and then to the antenna for broadcast. If it is intended for the signal to be transmitted over a cable from one point to another, the signal may be routed to an optional line driver and out through the cable. One skilled in the relevant art(s) will recognize that other transmission media may be used.

### 3.3.8 Other Implementations.

The implementations described above are provided for purposes of illustration. These implementations are not intended to limit the invention. Other implementation embodiments are possible and covered by the invention, such as but not limited to software, software/hardware, and firmware implementations of the systems and components of the invention. Alternative implementations and embodiments, differing slightly or substantially from those described herein, will be apparent to persons skilled in the relevant art(s) based on the teachings contained herein. Such alternative implementations fall within the scope of the present invention.

### 4. Harmonic Enhancement.

### 4.1 High Level Description.

This section (including its subsections) provides a high-level description of harmonic enhancement according to the present invention. In particular, pulse shaping is described at a high-level. Also, a structural implementation for achieving this process is described at a high-level. This structural implementation is described herein for illustrative purposes, and is not limiting. In particular, the process described in this section can be achieved using any number of structural implementations, one of which is described in this section. The details of such structural implementations will be apparent to persons skilled in the relevant art(s) based on the teachings contained herein.

It is noted that some embodiments of the invention include harmonic enhancement, whereas other embodiments do not.

### 4.1.1 Operational Description.

To better understand the generation and extraction of harmonics, and the purpose behind shaping the waveforms to enhance the harmonics, the following discussion of Fourier analysis as it applies to the present invention is offered.

A discovery made by Baron Jean B. J. Fourier (1768-1830) showed that continuous and periodic waveforms are comprised of a plurality of sinusoidal components, called harmonics. More importantly, the frequency of these components are integer multiples of the frequency of the original waveform (called the fundamental frequency). The amplitude of each of these component waveforms depends on the shape of the original waveform. The derivations and proofs of Baron Fourier's analysis are well known to those skilled in the relevant art(s).

The most basic waveform which is continuous and periodic is a sine wave. It has but one harmonic, which is at the fundamental frequency. This is also called the first harmonic. Since it only has one component, the amplitude of the harmonic component is equal to the amplitude of the original waveform, i.e., the sine wave itself. The sine wave is not considered to be "harmonically rich."

An impulse train is the other extreme case of a periodic waveform. Mathematically, it is considered to have zero width. The mathematical analysis in this case shows that there are harmonics at all multiples of the frequency of the impulse. That is, if the impulse has a frequency of $F_i$, then the harmonics are sinusoidal waves at $1 \cdot F_i$, $2 \cdot F_i$, $3 \cdot F_i$, $4 \cdot F_i$, etc. As the analysis also shows in this particular case, the amplitude of all of the harmonics are equal. This is indeed, a "harmonically rich" waveform, but is realistically impractical with current technology.

A more typical waveform is a rectangular wave, which is a series of pulses. Each pulse will have a width (called a pulse width, or "$\tau$"), and the series of pulses in the waveform will have a period ("T" which is the inverse of the frequency, i.e., $T=1/F_r$, where "$F_r$" is the fundamental frequency of the rectangular wave). One form of rectangular wave is the square wave, where the signal is at a first state (e.g., high) for the same amount of time that it is at the second state (e.g., low). That is, the ratio of the pulse width to period ($\tau/T$) is 0.5. Other forms of rectangular waves, other than square waves, are typically referred to simply as "pulses," and have $\tau/T < 0.5$ (i.e., the signal will be "high" for a shorter time than it is "low"). The mathematical analysis shows that there are harmonics at all of the multiples of the fundamental frequency of the signal. Thus, if the frequency of the rectangular waveform is $F_r$, then the frequency of the first harmonic is $1 \cdot F_r$, the frequency of the second harmonic is $2 \cdot F_r$, the frequency of the third harmonic is $3 \cdot F_r$, and so on. There are some harmonics for which the amplitude is zero. In the case of a square wave, for example, the "null points" are the even harmonics. For other values of $\tau/T$, the "null points" can be determined from the mathematical equations. The general equation for the amplitude of the harmonics in a rectangular wave having an amplitude of $A_{pulse}$ is as follows:

$$\text{Amplitude}(n^{th}\ \text{harmonic}) = A_n = \{[A_{pulse}][(2/\pi)/n]\sin[n\bullet\pi\bullet(\tau/T)]\} \qquad \underline{\textit{Eq. 1}}$$

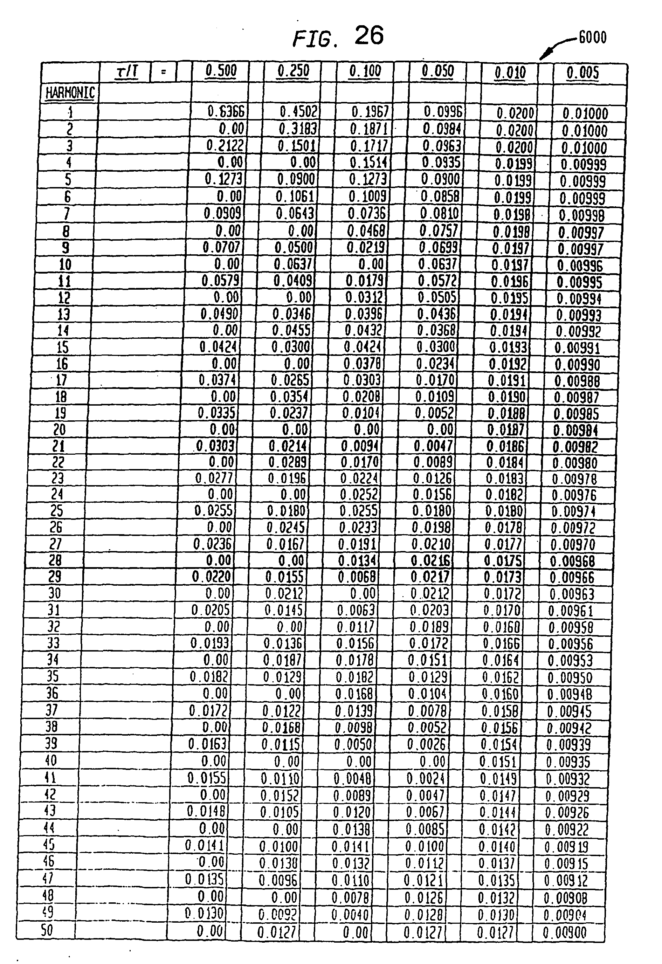

Table 6000 of FIG. 26 shows the amplitudes of the first fifty harmonics for rectangular waves having six different $\tau/T$ ratios. The $\tau/T$ ratios are 0.5 (a square wave), 0.25, 0.10, 0.05, 0.01, and 0.005. (One skilled in the relevant art(s) will recognize that $A_{pulse}$ is set to unity for mathematical comparison.) From this limited example, it can be seen that the ratio of pulse width to period is a significant factor in determining the relative amplitudes of the harmonics. Notice too, that for the case where $\tau/T=0.5$ (i.e., a square wave), the relationship stated above (i.e., only odd harmonics are present) holds. Note that as $\tau/T$ becomes small (i.e., the pulse approaches an impulse), the amplitudes of the harmonics becomes substantially "flat." That is, there is very little decrease in the relative amplitudes of the harmonics. One skilled in the relevant art(s) will understand how to select the desired pulse width for any given application based on the teachings contained herein. It can also be shown mathematically and experimentally that if a signal with a continuous and periodic waveform is modulated, that modulation is also present on every harmonic of the original waveform.

From the foregoing, it can be seen how pulse width is an important factor in assuring that the harmonic waveform at the desired output frequency has sufficient amplitude to be useful without requiring elaborate filtering or unnecessary amplification.

Another factor in assuring that the desired harmonic has sufficient amplitude is how the switch 2816 and 3116 (FIG. 10A) in the switch module 2802 responds to the control signal that causes the switch to close and to open (i.e., the modulated oscillating signal 2804 of FIG. 10). In general, switches have two thresholds. In the case of a switch that is normally open, the first threshold is the voltage required to cause the switch to close. The second threshold is the voltage level at which the switch will again open. The convention used herein for ease of illustration and discussion (and not meant to be limiting) is for the case where the switch is closed when the control signal is high, and open when the control signal is low. It would be apparent to one skilled in the relevant art(s) that the inverse could also be used. Typically, these voltages are not identical, but they may be. Another factor is how rapidly the switch responds to the control input once the threshold voltage has been applied. The objective is for the switch to close and open such that the bias/reference signal is "crisply" gated. That is, preferably, the impedance through the switch must change from a high impedance (an open switch) to a low impedance (a closed switch) and back again in a very short time so that the output signal is substantially rectangular.

It is an objective of this invention in the transmitter embodiment that the intelligence in the information signal is to be transmitted. That is, the information is modulated onto the transmitted signal. To achieve this objective, the information signal is used to modulate the oscillating signal 2804. The oscillating signal 2804 then causes the switch 2816 to close and open. The information that is modulated onto the oscillating signal 2804 must be faithfully reproduced onto the signal that is output from the switch circuit (i.e., the harmonically rich signal 2814). For this to occur efficiently, in embodiments of the invention, the switch 2816 preferably closes and opens crisply so that the harmonically rich signal 2814 changes rapidly from the bias/reference signal 2806 to ground 2812 (or the second signal level 2818 in the alternative embodiment). This rapid rise and fall time is desired so that the harmonically rich signal 2814 will be "harmonically rich."

For the switch 2816 to close and open crisply, the oscillating signal 2804 must also be crisp. If the oscillating signal 2804 is sinusoidal, the switch 2816 will open and close when the threshold voltages are reached, but the pulse width of the harmonically rich signal 2814 may not be as small as is needed to ensure the amplitude of the desired harmonic of the harmonically rich signal 2814 is sufficiently high to allow transmission without elaborate filtering or unnecessary amplification. Also, in the embodiment wherein the switch 2816 is a GaAs FET 2901, if the oscillating signal 2804 that is connected to the gate 2902 of the GaAs FET 2901 (i.e., the signal that causes the switch 2816 to close and open) is a sinusoidal wave, the GaAs FET 2901 will not crisply close and open, but will act more like an amplifier than a switch. (That is, it will conduct during the time that the oscillating signal is rising and falling below the threshold voltages, but will not be a "short.") In order to make use of the benefits of a GaAs FET's capability to close and open at high frequencies, the oscillating signal 2804 connected to the gate 2902 preferably has a rapid rise and fall time. That is, it is preferably a rectangular waveform, and preferably has a pulse width to period ratio the same as the pulse width to period ratio of the harmonically rich signal 2814.

As stated above, if a signal with a continuous and periodic waveform is modulated, that modulation occurs on every harmonic of the original waveform. When the information is modulated onto the oscillating signal 2804 and the oscillating signal 2804 is used to cause the switch 2816 to close and open, the resulting harmonically rich signal 2814 that is output from the switch module 2802 will also be modulated. If the oscillating signal 2804 is crisp, the switch 2816 will close and open crisply, the harmonically rich signal 2814 will be harmonically rich, and each of the harmonics of the harmonically rich signal 2814 will have the information modulated on it.

Because it is desired that the oscillating signal 2804 be crisp, harmonic enhancement may be needed in some embodiments. Harmonic enhancement may also be called "pulse shaping" since the purpose is to shape the oscillating signal 2804 into a string of pulses of a desired pulse width. If the oscillating signal is sinusoidal, harmonic enhancement will shape the sinusoidal signal into a rectangular (or substantially rectangular) waveform with the desired pulse width to period ratio. If the oscillating signal 2804 is already a square wave or a pulse, harmonic enhancement will shape it to achieve the desired ratio of pulse width to period. This will ensure an efficient transfer of the modulated information through the switch.

Three exemplary embodiments of harmonic enhancement are described below for illustrative purposes. However, the invention is not limited to these embodiments. Other embodiments will be apparent to persons skilled in the relevant art(s) based on the teachings contained herein.

### 4.1.2 Structural Description.

The shape of the oscillating signal 2804 causes the switch 2816 to close and open. The shape of the oscillating signal 2804 and the selection of the switch 2816 will determine how quickly the switch 2816 closes and opens, and how long it stays closed compared to how long it stays open. This then will determine the "crispness" of the harmonically rich signal 2814. (That is, whether the harmonically rich signal 2814 is substantially rectangular, trapezoidal, triangular, etc.) As shown above, in order to ensure that the desired harmonic has the desired amplitude, the shape of the oscillating signal 2804 should be substantially optimized.

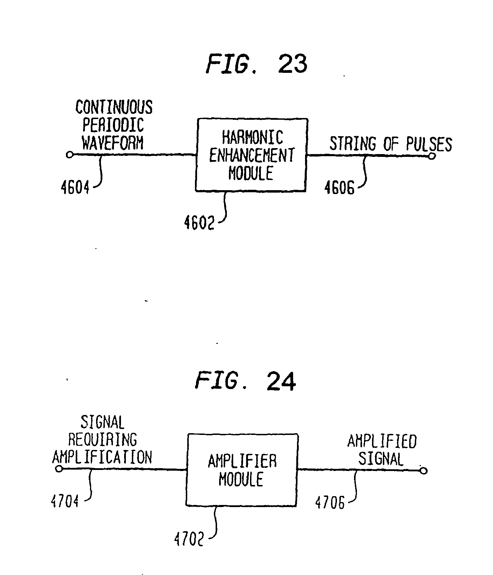

The harmonic enhancement module (HEM) 4602 (FIG. 23) is also referred to as a "pulse shaper." It "shapes" the oscillating signal 2804 that drives the switch module 2802 described in sections 3.3.4-3.3.4.2. Harmonic enhancement module 4602 preferably transforms a continuous and periodic waveform 4604 into a string of pulses 4606. The string of pulses 4606 will have a period, "T," determined by both the frequency of the continuous and periodic waveform 4604 and the design of the pulse shaping circuit within the harmonic enhancement module 4602. Also, each pulse will have a pulse width, "$\tau$," determined by the design of the pulse shaping circuit. The period of the pulse stream, "T," determines the frequency of the switch closing (the frequency being the inverse of the period), and the pulse width of the pulses, "$\tau$," determines how long the switch stays closed.

In the embodiment described above in sections 3.3.4-3.3.4.2, when the switch 2816 is open, the harmonically rich signal 2814 will have an amplitude substantially equal to the bias signal 2806. When the switch 2816 is closed, the harmonically rich signal 2814 will have an amplitude substantially equal to the potential of signal 2812 or 2818 of the second input 2810 of the switch module 2802. Thus, for the case where the oscillating signal 2804 driving the switch module 2802 (or 3102) is substantially rectangular, the harmonically rich signal 2814 will have substantially the same frequency and pulse width as the shaped oscillating signal 2804 that drives the switch module 2802. This is true for those cases wherein the oscillating signal 2804 is a rectangular wave. One skilled in the relevant art(s) will understand that the term "rectangular wave" can refer to all waveforms that are substantially rectangular, including square waves and pulses.

The purpose of shaping the signal is to control the amount of time that the switch 2816 is closed. As stated above, the harmonically rich signal 2814 has a substantially rectangular waveform. Controlling the ratio of the pulse width of the harmonically rich signal 2814 to its period will result in the shape of the harmonically rich signal 2814 being substantially optimized so that the relative amplitudes of the harmonics are such that the desired harmonic can be extracted without unnecessary and elaborate amplification and filtering.

### 4.2 Exemplary Embodiments.

Various embodiments related to the method(s) and structure(s) described above are presented in this section (and its subsections). These embodiments are described herein for purposes of illustration, and not limitation. The invention is not limited to these embodiments. Alternative embodiments will be apparent to persons skilled in the relevant art(s) based on the teachings contained herein. The invention is intended and adapted to include such alternative embodiments.

### 4.2.1 First Embodiment: When a Square Wave Feeds the Harmonic Enhancement Module to Create One Pulse per Cycle.

### 4.2.1.1 Operational Description.

According to this embodiment, a continuous periodic waveform 4604 is received and a string of pulses 4606 is output. The continuous periodic waveform 4604 may be a square wave or any other continuous periodic waveform that varies from a value recognized as a "digital low" to a value recognized as a "digital high." One pulse is generated per cycle of the continuous and periodic waveform 4604. The description given herein will be for the continuous periodic waveform 4604 that is a square wave, but one skilled in the relevant art(s) will appreciate that other waveforms may also be "shaped" into waveform 4606 by this embodiment.

### 4.2.1.2 Structural Description.

In this first embodiment of a harmonic enhancement module 4602, herein after referred to as a pulse shaping circuit 4602, a continuous periodic waveform 4604 that is a square wave is received by the pulse shaping circuit 4602. The pulse shaping circuit 4602 is preferably comprised of digital logic devices that result in a string of pulses 4606 being output that has one pulse for every pulse in the continuous periodic waveform 4604, and preferably has a $\tau/T$ ratio less than 0.5.

### 4.2.2 Second Embodiment: When a Square Wave Feeds the Harmonic Enhancement Module to Create Two Pulses per Cycle.

### 4.2.2.1 Operational Description.

In this embodiment, a continuous periodic waveform 4604 is received and a string of pulses 4606 is output. In this embodiment, there are two pulses output for every period of the continuous periodic waveform 4604. The continuous periodic waveform 4604 may be a square wave or any other continuous periodic waveform that varies from a value recognized as a "digital low" to a value recognized as a "digital high." The description given herein will be for a continuous periodic waveform 4604 that is a square wave, but one skilled in the relevant art(s) will appreciate that other waveforms may also be "shaped" into waveform 4606 by this embodiment.

### 4.2.2.2 Structural Description.

In this second embodiment of a pulse shaping circuit 4602, a continuous periodic waveform 4604 that is a square wave is received by the pulse shaping circuit 4602. The pulse shaping circuit 4602 is preferably comprised of digital logic devices that result in a string of pulses 4606 being output that has two pulses for every pulse in the continuous periodic waveform 4604, and preferably has a $\tau/T$ ratio less than 0.5.

### 4.2.3 Third Embodiment: When Any Waveform Feeds the Module.

### 4.2.3.1 Operational Description.

In this embodiment, a continuous periodic waveform 4604 of any shape is received and a string of pulses 4606 is output.

### 4.2.3.2 Structural Description.

In this third embodiment of a pulse shaping circuit 4602, a continuous periodic waveform 4604 of any shape is received by the pulse shaping circuit 4602. The pulse shaping circuit 4602 is preferably comprised of a series of stages, each stage shaping the waveform until it is substantially a string of pulses 4606 with preferably a $\tau/T$ ratio less than 0.5.

### 4.2.4 Other Embodiments.

The embodiments described above are provided for purposes of illustration. These embodiments are not intended to limit the invention. Alternative embodiments, differing slightly or substantially from those described herein, will be apparent to persons skilled in the relevant art(s) based on the teachings contained herein. Such alternative embodiments fall within the scope of the present invention.

### 4.3 Implementation Examples.

Exemplary operational and/or structural implementations related to the method(s), structure(s), and/or embodiments described above are presented in this section (and its subsections). These components and methods are presented herein for purposes of illustration, and not limitation. The invention is not limited to the particular examples of components and methods described herein. Alternatives will be apparent to persons skilled in the relevant art(s) based on the teachings contained herein. Such alternatives fall within the scope of the present invention.

### 4.3.1 First Digital Logic Circuit.

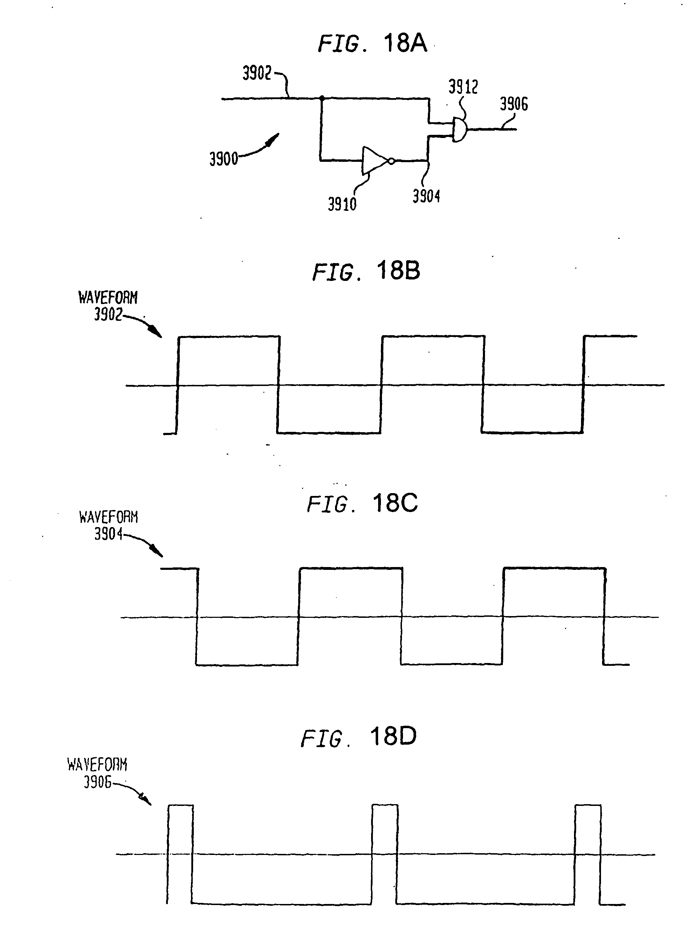

An exemplary implementation of the first embodiment described in sections 4.2.1-4.2.1.2 is illustrated in FIG. 18. In particular, the circuit shown in FIG. 18A is a typical circuit design for a pulse shaping circuit 4602 using digital logic devices. Also shown in FIGs. 18B-18D are representative waveforms at three nodes within the circuit. In this embodiment, pulse shaper 3900 uses an inverter 3910 and an AND gate 3912 to produce a string of pulses. An inverter, such as inverter 3910, changes the sign of the input, and an AND gate, such as AND gate 3912, outputs a digital "high' when all of the input signals are digital "highs." The input to pulse shaper 3900 is waveform 3902, and, for illustrative purposes, is shown here as a square wave. The output of inverter 3910 is waveform 3904, which is also a square wave. However, because of the circuitry of the inverter 3910, there is a delay between the application of the input and the corresponding sign change of the output. If waveform 3902 starts "low," waveform 3904 will be "high" because it has been inverted by inverter 3910. When waveform 3902 switches to "high," AND gate 3912 will momentarily see two "high" signals, thus causing its output waveform 3906 to be "high." When inverter 3910 has inverted its input (waveform 3902) and caused waveform 3904 to become "low," AND gate 3912 will then see only one "high" signal, and the output waveform 3906 will become "low." Thus, the output waveform 3906 will be "high" for only the period of time that both waveforms 3902 and 3904 are high, which is the time delay of the inverter 3910. Accordingly, as is apparent from FIGs. 18B-18D, pulse shaper 3900 receives a square wave and generates a string of pulses, with one pulse generated per cycle of the square wave.

### 4.3.2 Second Digital Logic Circuit.

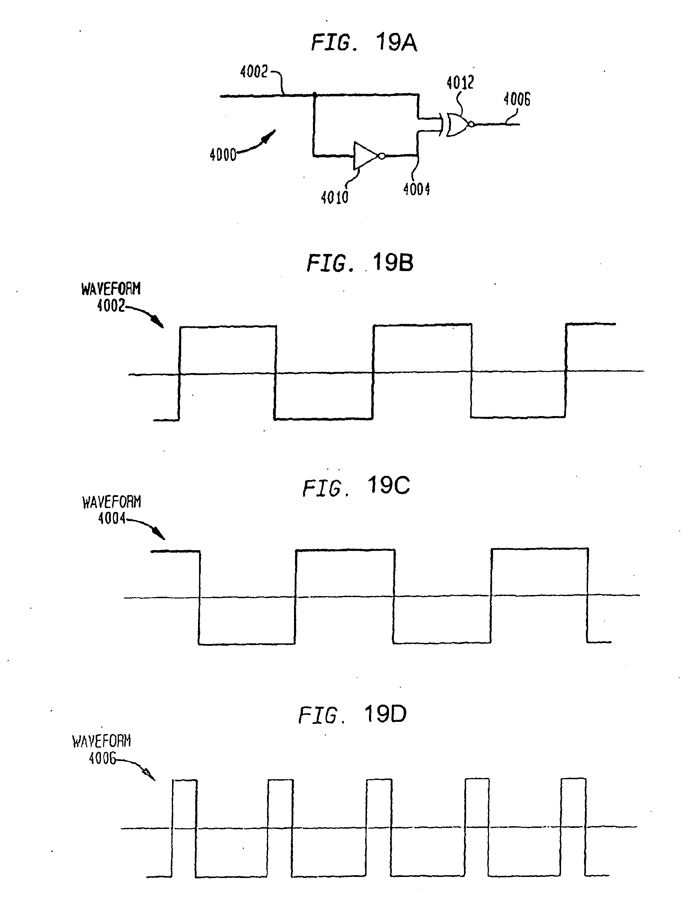

An exemplary implementation of the second embodiment described in sections 4.2.2-4.2.2.2 is illustrated in FIG. 19. In particular, the circuit of FIG. 19A is a typical circuit design for a pulse shaping circuit 4602 using digital logic devices. Also shown in FIGs. 19B-19D are representative waveforms at three nodes within the circuit. In this embodiment, pulse shaping circuit 4000 uses an inverter 4010 and an exclusive NOR (XNOR) gate 4012. An XNOR, such as XNOR 4012, outputs a digital "high" when both inputs are digital "highs" and when both signals are digital "lows." Waveform 4002, which is shown here as a square wave identical to that shown above as waveform 3902, begins in the "low" state. Therefore, the output of inverter 4010 will begin at the "high" state. Thus, XNOR gate 4012 will see one "high" input and one "low" input, and its output waveform 4006 will be "low." When waveform 4002 changes to "high," XNOR gate 4012 will have two "high" inputs until the waveform 4004 switches to "low." Because it sees two "high" inputs, its output waveform 4006 will be "high." When waveform 4004 becomes "low," XNOR gate 4012 will again see one "high" input (waveform 4002) and one "low" input (waveform 4004). When waveform 4002 switches back to "low," XNOR gate 4012 will see two "low" inputs, and its output will become "high." Following the time delay of inverter 4010, waveform 4004 will change to "high," and XNOR gate 4012 will again see one "high" input (waveform 4004) and one "low" input (waveform 4002). Thus, waveform 4006 will again switch to "low." Accordingly, as is apparent from FIGs. 19B-19D, pulse shaper 4000 receives a square wave and generates a string of pulses, with two pulses generated per cycle of the square wave.

### 4.3.3 Analog Circuit.

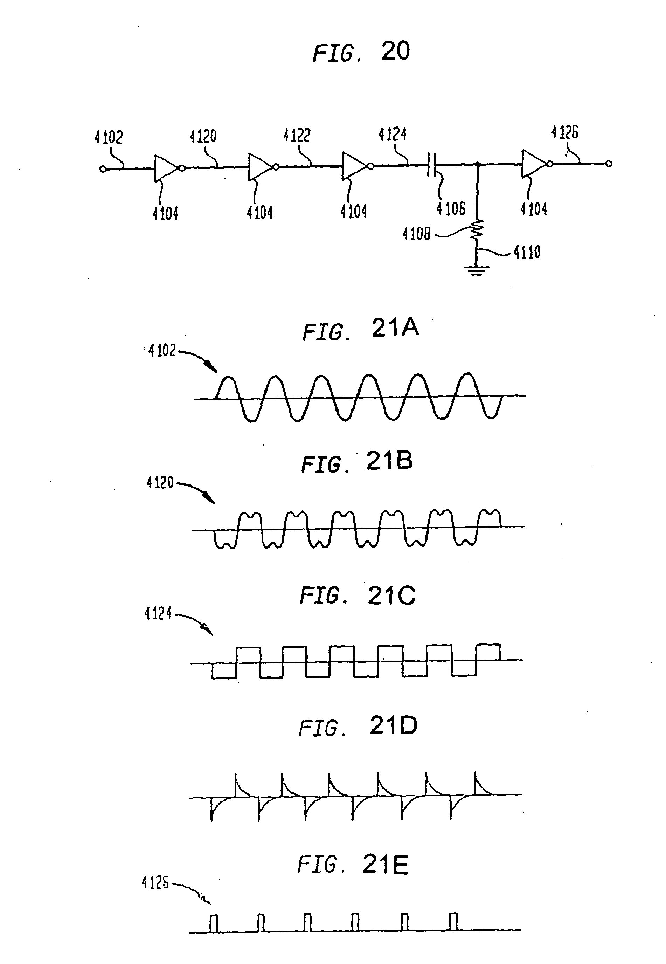

An exemplary implementation of the third embodiment described in sections 4.2.3-4.2.3.2 is illustrated in FIG. 20. In particular, the circuit shown in FIG. 20 is a typical pulse shaping circuit 4602 where an input signal 4102 is shown as a sine wave. Input signal 4102 feeds the first circuit element 4104, which in turn feeds the second, and so on. Typically, three circuit elements 4104 produce incrementally shaped waveforms 4120, 4122, and 4124 before feeding a capacitor 4106. The output of capacitor 4106 is shunted to ground 4110 through a resistor 4108 and also feeds a fourth circuit element 4104. An output signal 4126 is a pulsed output, with a frequency that is a function of the frequency of input signal 4102.

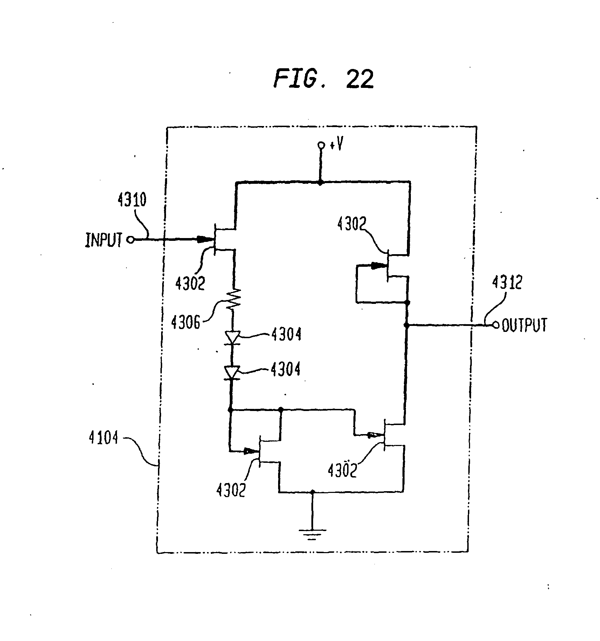

An exemplary circuit for circuit elements 4104 is shown in FIG. 22. Circuit 4104 is comprised of an input 4310, an output 4312, four FETs 4302, two diodes 4304, and a resistor 4306. One skilled in the relevant art(s) would recognize that other pulse shaping circuit designs could also be used without deviating from the scope of the invention.

### 4.3.4 Other Implementations.

The implementations described above are provided for purposes of illustration. These implementations are not intended to limit the invention. Alternative implementations, differing slightly or substantially from those described herein, will be apparent to persons skilled in the relevant art(s) based on the teachings contained herein. Such alternative implementations fall within the scope of the present invention.

### 5. Amplifier Module.

### 5.1 High Level Description.

This section (including its subsections) provides a high-level description of the amplifier module according to the present invention. In particular, amplification is described at a high-level. Also, a structural implementation for achieving signal amplification is described at a high-level. This structural implementation is described herein for illustrative purposes, and is not limiting. In particular, the process described in this section can be achieved using any number of structural implementations, one of which is described in this section. The details of such structural implementations will be apparent to persons skilled in the relevant art(s) based on the teachings contained herein.

### 5.1.1 Operational Description.

Even though the present invention is intended to be used without requiring amplification, there may be circumstance when, in the embodiment of the present invention wherein it is being used as a transmitter, it may prove desirable to amplify the modulated signal before it is transmitted. In another embodiment of the invention wherein it is being used as a stable signal source for a frequency or phase comparator, it may also be desirable to amplify the resultant signal at the desired frequency.

The requirement may come about for a number of reasons. A first may be that the bias/reference signal is too low to support the desired use. A second may be because the desired output frequency is very high relative to the frequency of the oscillating signal that controls the switch. A third reason may be that the shape of the harmonically rich signal is such that the amplitude of the desired harmonic is low.

In the first case, recall that the amplitude of the bias/reference signal determines the amplitude of the harmonically rich signal which is present at the output of the switch circuit. (See sections 3.3.4-3.3.4.2.) Further recall that the amplitude of the harmonically rich signal directly impacts the amplitude of each of the harmonics. (See the equation in section 4.1, above.)

In the second instance, if the frequency of the oscillating signal is relatively low compared to the desired output frequency of the up-converter, a high harmonic will be needed. As an example, if the oscillating signal is 60 MHz, and the desired output frequency is at 900 MHz, the 15$^{th}$ harmonic will be needed. In the case where $\tau/T$ is 0.1, it can be seen from Table 6000 of FIG. 26 that the amplitude of the 15$^{th}$ harmonic ($A_{15}$) is 0.0424, which is 21.5% of the amplitude of the first harmonic ($A_1 = 0.197$). There may be instances wherein this is insufficient for the desired use, and consequently it must be amplified.

The third circumstance wherein the amplitude of the output may need to be amplified is when the shape of the harmonically rich signal is not "crisp" enough to provide harmonics with enough amplitude for the desired purpose. If, for example, the harmonically rich signal is substantially triangular, and given the example above where the oscillating signal is 60 MHz and the desired output signal is 900 MHz, the 15$^{th}$ harmonic of the triangular wave is 0.00180. This is significantly lower than the amplitude of the 15$^{th}$ harmonic of the "0.1" rectangular wave (shown above to be 0.0424) and can be mathematically shown to be 0.4% of the amplitude of the 1$^{st}$ harmonic of the triangular wave (which is 0.405). Thus, in this example, the 1$^{st}$ harmonic of the triangular wave has an amplitude that is larger than the amplitude of the 1$^{st}$ harmonic of the "0.1" rectangular wave, but at the 15$^{th}$ harmonic, the triangular wave is significantly lower than the "0.1" rectangular wave.

Another reason that the desired harmonic may need to be amplified is that circuit elements such as the filter may cause attenuation in the output signal for which a designer may wish to compensate.

The desired output signal can be amplified in a number of ways. One is to amplify the bias/reference signal to ensure that the amplitude of the harmonically rich wave form is high. A second is to amplify the harmonically rich waveform itself. A third is to amplify the desired harmonic only. The examples given herein are for illustrative purposes only and are not meant to be limiting on the present invention. Other techniques to achieve amplification of the desired output signal would be apparent to those skilled in the relevant art(s).

### 5.1.2 Structural Description.

In one embodiment, a linear amplifier is used to amplify the bias/reference signal. In another embodiment, a linear amplifier is used to amplify the harmonically rich signal. And in yet another embodiment, a linear amplifier is used to amplify the desired output signal. Other embodiments, including the use of non-linear amplifiers, will be apparent to persons skilled in the relevant art(s).

### 5.2 Exemplary Embodiment.

An embodiment related to the method(s) and structure(s) described above is presented in this section (and its subsections). This embodiment is described herein for purposes of illustration, and not limitation. The invention is not limited to this embodiment. Alternative embodiments will be apparent to persons skilled in the relevant art(s) based on the teachings contained herein. The invention is intended and adapted to include such alternative embodiments.

### 5.2.1 Linear Amplifier.

The exemplary linear amplifier described herein will be directed towards an amplifier composed of solid state electronic devices to be inserted in the circuit at one or more points. Other amplifiers suitable for use with the invention will be apparent to persons skilled in the relevant art(s). As shown in FIG. 24, an amplifier module 4702 receives a signal requiring amplification 4704 and outputs an amplified signal 4706. It would be apparent to one skilled in the relevant art (s) that a plurality of embodiments may be employed without deviating from the scope of the invention described herein.

### 5.2.1.1 Operational Description.

The desired output signal can be amplified in a number of ways. Such amplification as described in the section may be in addition to the techniques described above to enhance the shape of the harmonically rich signal by pulse shaping of the oscillating signal that causes the switch to close and open.

### 5.2.1.2 Structural Description.

In one embodiment, a linear amplifier is placed between the bias/reference signal and the switch module. This will increase the amplitude of the bias/reference signal, and as a result, will raise the amplitude of the harmonically rich signal that is the output of the switch module. This will have the effect of not only raising the amplitude of the harmonically rich signal, it will also raise the amplitude of all of the harmonics. Some potential limitation of this embodiment are: the amplified bias/reference signal may exceed the voltage design limit for the switch in the switch circuit; the harmonically rich signal coming out of the switch circuit may have an amplitude that exceeds the voltage design limits of the filter; and/or unwanted distortion may occur from having to amplify a wide bandwidth signal.

A second embodiment employs a linear amplifier between the switch module and the filter. This will raise the amplitude of the harmonically rich signal. It will also raise the amplitude of all of the harmonics of that signal. In an alternative implementation of this embodiment, the amplifier is tuned so that it only amplifies the desired frequencies. Thus, it acts both as an amplifier and as a filter. A potential limitation of this embodiment is that when the harmonically rich signal is amplified to raise a particular harmonic to the desired level the amplitude of the whole waveform is amplified as well. For example, in the case where the amplitude of the pulse, $A_{pulse}$, is equal to 1.0, to raise the 15th harmonic from 0.0424 volts to 0.5 volts, the amplitude of each pulse in the harmonically rich signal, $A_{pulse}$, will increase from 1.0 to 11.8 volts. This may well exceed the voltage design limit of the filter.

A third embodiment of an amplifier module will place a linear amplifier between the filter and the transmission module. This will only raise the amplitude of the desired harmonic, rather than the entire harmonically rich signal.

Other embodiments, such as the use of non-linear amplifiers, will be apparent to one skilled in the relevant art (s), and will not be described herein.

### 5.2.2 Other Embodiments.

The embodiments described above are provided for purposes of illustration. These embodiments are not intended to limit the invention. Alternative embodiments, differing slightly or substantially from those described herein, will be apparent to persons skilled in the relevant art(s) based on the teachings contained herein. Such alternative embodiments fall within the scope of the present invention.

### 5.3 Implementation Examples.

Exemplary operational and/or structural implementations related to the method(s), structure(s), and/or embodiments described above are presented in this section (and its subsections). These components and methods are presented herein for purposes of illustration, and not limitation. The invention is not limited to the particular examples of components and methods described herein. Alternatives will be apparent to persons skilled in the relevant art(s) based on the teachings contained herein. Such alternatives fall within the scope of the present invention.

### 5.3.1 Linear Amplifier.

Although described below as if it were placed after the filter, the amplifier may also be placed before the filter without deviating from the intent of the invention

### 5.3.1.1 Operational Description.

According to embodiments of the invention, a linear amplifier receives a first signal at a first amplitude, and outputs a second signal at a second amplitude, wherein the second signal is proportional to the first signal. It is a objective of an amplifier that the information embedded onto the first signal waveform will also be embedded onto the second signal. Typically, it is desired that there be as little distortion in the information as possible.

In a preferred embodiment, the second signal is higher in amplitude than the first signal, however, there may be implementations wherein it is desired that the second signal be lower than the first signal (i.e., the first signal will be attenuated).

### 5.3.1.2 Structural Description.

The design and use of a linear amplifier is well known to those skilled in the relevant art(s). A linear amplifier may be designed and fabricated from discrete components, or it may be purchased "off the shelf."

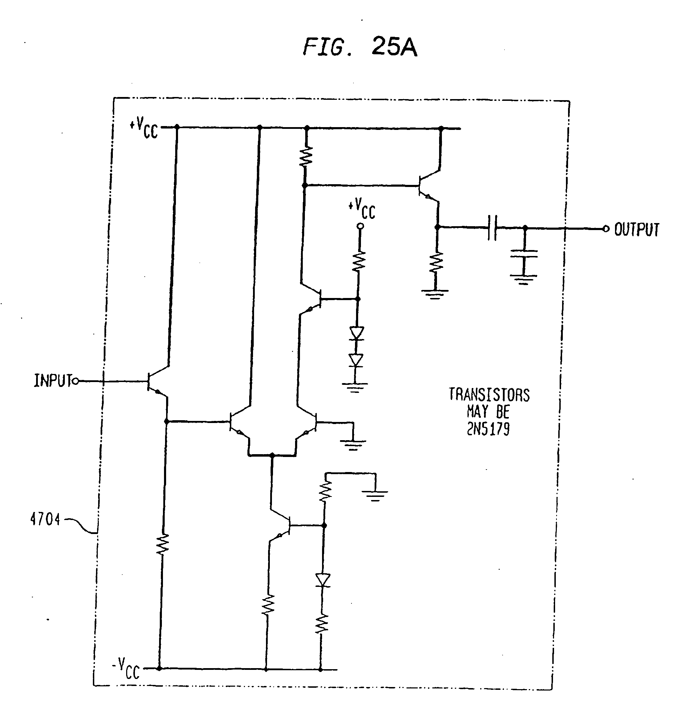

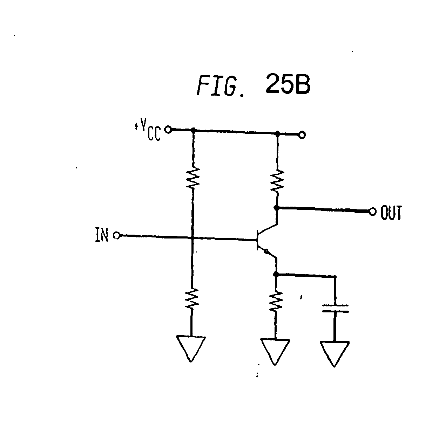

Exemplary amplifiers are seen in FIG. 25. In the exemplary circuit diagram of FIG. 25A, six transistors are used in a wideband amplifier. In the more basic exemplary circuit of FIG. 25B, the amplifier is composed of one transistor, four resistors, and a capacitor. Those skilled in the relevant art(s) will recognize that numerous alternative designs may be used.

### 5.3.2 Other Implementations.

The implementations described above are provided for purposes of illustration. These implementations are not intended to limit the invention. Alternative implementations, differing slightly or substantially from those described herein, will be apparent to persons skilled in the relevant art(s) based on the teachings contained herein. Such alternative implementations fall within the scope of the present invention.

### Claims

1.  An apparatus for up-conversion of phase-modulated IQ signals, **characterised by**:

    at least one first switch module (1822, 2802) that receives at least a first phase-modulated oscillating signal (1820, 2804) and a first bias signal (2806), wherein said first phase-modulated oscillating signal (1820, 2804) causes said at least one first switch module (1822, 2802) to gate said first bias signal (2806), and thereby generate a first periodic signal (1824, 2814) having a first plurality of harmonics;
    at least one second switch module (1828, 2802) that receives at least a second phase-modulated oscillating signal (1826, 2804) and a second bias signal (2806), wherein said second phase-modulated oscillating signal (1826, 2804) causes said at least one second switch module (1828, 2802) to gate said second bias signal (1826), and thereby generate a second periodic signal (1830, 2814) having a second plurality of harmonics;
    a summer (1832) that combines said first periodic signal (1824) and said second periodic signal (1830) to thereby generate a combined periodic signal (1834) having a combined plurality of harmonics; and
    at least one filter (1836) that receives said combined periodic signal (1834), wherein said at least one filter (1836) isolates at least one harmonic of said combined plurality of harmonics.

2.  The apparatus of claim 1, wherein said first phase-modulated oscillating signal (1820) represents an I information signal, and said second phase-modulated oscillating signal (1826) represents a Q information signal.

3.  The apparatus of claim 1 or 2, further comprising a pulse shaper (4602) for shaping the first phase-modulated oscillating signal (1820, 4604) into a pulse-shaped signal (4606).

4.  The apparatus of claim 3, wherein the pulse-shaped signal (4606) comprises a phase modulated rectangular wave signal.

**5.** A method of up-conversion of phase-modulated IQ signals, **characterised by** the steps of:

gating a first bias signal (1820, 2804) according to a first phase-modulated oscillating signal (2806) to generate a first harmonically rich signal (1824, 2814);
gating a second bias signal (1826, 2804) according to a second phase-modulated oscillating signal (2806) to generate a second harmonically rich signal (1830, 2814);
summing said first (1824) and second (1830) harmonically rich signals to form a combined harmonically rich signal (1834); filtering from said combined harmonically rich signal (1834) any undesired harmonics and transmitting the combined and filtered harmonically rich signal (1834) using an antenna.

**6.** The method of claim 5, further comprising:

shaping the first phase-modulated oscillating signal (1820, 4604) into a pulse-shaped signal (4606).

**7.** The method of claim 6, wherein the pulse-shaped signal (4606) comprises a phase-modulated rectangular wave signal.

**Patentansprüche**

**1.** Vorrichtung zum Aufwärtswandeln eines phasenmodulierten IQ-Signals, **gekennzeichnet durch**:

mindestens ein erstes Schaltmodul (1822, 2802), das mindestens ein erstes phasenmoduliertes Oszillationssignal (1820, 2804) und ein erstes Bezugssignal (2806) empfängt, wobei das erste phasenmodulierte Oszillationssignal (1820, 2804) das mindestens eine erste Schaltmodul (1822, 2802) veranlasst, das erste Bezugssignal (2806) zu torsteuern und **dadurch** ein erstes periodisches Signal (1824, 2814) mit einer ersten Mehrzahl von Harmonischen zu erzeugen,
mindestens ein zweites Schaltmodul (1828, 2802), das mindestens ein zweites phasenmoduliertes Oszillationssignal (1826, 2804) und ein zweites Bezugssignal (2806) empfängt, wobei das zweite phasenmodulierte Oszillationssignal (1826, 2804) das mindestens eine zweite Schaltmodul (1828, 2802) veranlasst, das zweite Bezugssignal (1826) torzusteuern und **dadurch** ein zweites periodisches Signal (1830, 2814) mit einer zweiten Mehrzahl von Harmonischen zu erzeugen,
eine Summiereinrichtung (1832), die das erste periodische Signal (1824) und das zweite periodische Signal (1830) kombiniert und **dadurch** ein kombiniertes periodisches Signal (1834) mit einer kombinierten Mehrzahl von Harmonischen erzeugt, und
mindestens ein Filter (1836), das das kombinierte periodische Signal (1834) empfängt, wobei das mindestens eine Filter (1836) zumindest eine Harmonische der kombinierten Mehrzahl von Harmonischen isoliert.

**2.** Vorrichtung nach Anspruch 1, wobei das erste phasenmodulierte Oszillationssignal (1820) ein I-Informationssignal und das zweite phasenmodulierte Oszillationssignal (1826) ein Q-Informationssignal repräsentiert.

**3.** Vorrichtung nach Anspruch 1 oder 2, ferner mit einem Pulsformer (4602) zum Formen des ersten phasenmodulierten Oszillationssignals (1820, 4604) in ein impulsgeformtes Signal (4606).

**4.** Vorrichtung nach Anspruch 3, wobei das impulsgeformte Signal (4606) ein phasenmoduliertes Rechteck-Wellensignal aufweist.

**5.** Verfahren zum Aufwärtswandeln von phasenmodulierten IQ-Signalen, **gekennzeichnet durch** die folgenden Schritte:

Torsteuern eines ersten Bezugssignals (1820, 2804) entsprechend einem ersten phasenmodulierten Oszillationssignal (2806) zum Erzeugen eines ersten harmonischreichen Signals (1824, 2814),
Torsteuern eines zweiten Bezugssignals (1826, 2804) entsprechend einem zweiten phasenmodulierten Oszillationssignal (2806) zum Erzeugen eines zweiten harmonischreichen Signals (1830, 2814),
Summieren des ersten (1824) und zweiten (2830) harmonischreichen Signals zum Bilden eines kombinierten harmonischreichen Signals (1834),
Filtern unerwünschter Harmonischer aus dem kombinierten harmonischreichen Signal (1834), und
Senden des kombinierten und gefilterten harmonischreichen Signals (1834) unter Verwendung einer Antenne.

**6.** Verfahren nach Anspruch 5, ferner mit dem Schritt:

Formen des ersten phasenmodulierten Oszillationssignals (1820, 4604) in ein impulsgeformtes Signal (4606).

**7.** Verfahren nach Anspruch 6, wobei das impulsgeformte Signal (4606) ein phasenmoduliertes Rechteck-Wellensignal aufweist.

**Revendications**

**1.** Dispositif de transposition par montée en fréquence de signaux I/Q à modulation de phase, **caractérisé par** :

au moins un premier module de commutation (1822, 2802) qui reçoit au moins un premier signal oscillant à modulation de phase (1820, 2804) et un premier signal de polarisation (2806), ledit premier signal oscillant à modulation de phase (1820, 2804) amenant ledit moins un premier module de commutation (1822, 2802) à déclencher ledit premier signal de polarisation (2806), et de ce fait à générer un premier signal périodique (1824, 2814) ayant une première pluralité d'harmoniques ;
au moins un second module de commutation (1828, 2802) qui reçoit au moins un second signal oscillant à modulation de phase (1826, 2804) et un second signal de polarisation (2806), ledit second signal oscillant à modulation de phase (1826, 2804) amenant ledit moins un second module de commutation (1828, 2802) à déclencher ledit second signal de polarisation (1826), et de ce fait à générer un second signal périodique (1830, 2814) ayant une seconde pluralité d'harmoniques ;
un sommateur (1832) qui combine ledit premier signal périodique (1824) et ledit second signal périodique (1830) pour ainsi générer un signal périodique combiné (1834) ayant une pluralité combinée d'harmoniques ; et
au moins un filtre (1836) qui reçoit ledit signal périodique combiné (1834), ledit au moins un filtre (1836) isolant au moins un harmonique de ladite pluralité combinée d'harmoniques.

**2.** Dispositif selon la revendication 1, dans lequel ledit premier signal oscillant à modulation de phase (1820) représente un signal d'information 1 et ledit second signal oscillant à modulation de phase (1826) représente un signal d'information Q.

**3.** Dispositif selon la revendication 1 ou 2, comportant en outre un moyen de mise en forme (4602) d'impulsions pour transformer le premier signal oscillant à modulation de phase (1820, 4604) en signal en forme d'impulsion (4606).

**4.** Dispositif selon la revendication 3, dans lequel le signal en forme d'impulsion (4606) comprend un signal ondulatoire rectangulaire à modulation de phase.

**5.** Procédé de transposition par montée en fréquence de signaux I/Q à modulation de phase, **caractérisé par** les étapes consistant à :

déclencher un premier signal de polarisation (1820, 2804) d'après un premier signal oscillant à modulation de phase (2806) pour générer un premier signal (1830, 2814) riche en harmoniques :

déclencher un second signal de polarisation (1826, 2804) d'après un second signal oscillant à modulation de phase (2806) pour générer un second signal (1830, 2814) riche en harmoniques ;
additionner lesdits premier (1824) et second (1830) signaux riches en harmoniques pour former un signal combiné (1834) riche en
filtrer ledit signal (1834) riche en harmoniques pour y supprimer d'éventuels harmoniques indésirables ; et
émettre le signal combiné et filtré (1834) riche en harmoniques à l'aide d'une antenne.

**6.** Procédé selon la revendication 5, comportant en outre :

la transformation du premier signal oscillant à modulation de phase (1820, 4604) en signal en forme d'impulsion (4606).

**7.** Procédé selon la revendication 6, dans lequel le signal en forme d'impulsion (4606) comprend un signal ondulatoire rectangulaire à modulation de phase.

## FIG. 1
### (RELATED ART)

IN PHASE/QUADRATURE PHASE MODULATION CIRCUIT

## FIG. 2A
(RELATED ART)

INFORMATION
SIGNAL #1
702

## FIG. 2B
(RELATED ART)

OSCILLATOR
SIGNAL #1
710

## FIG. 2C
(RELATED ART)

INFORMATION
SIGNAL #2
704

## FIG. 2D
(RELATED ART)

OSCILLATOR
SIGNAL #1
WITH 90° PHASE
SHIFT
712

## FIG. 2E
(RELATED ART)

MODULATED SIGNALS
(NOT SHOWN SUMMED)

724

722

## FIG. 3

### TRANSMITTER

900

| |
|---|
| INFORMATION SIGNAL GENERATED BY SOURCE | 902 |
| ↓ |
| OSCILLATING SIGNAL IS GENERATED | 904 |
| ↓ |
| OSCILLATING SIGNAL IS MODULATED | 906 |
| ↓ |
| SIGNAL WITH PERIODIC WAVEFORM IS GENERATED | 908 |
| ↓ |
| UNWANTED HARMONICS ARE FILTERED OUT | 910 |
| ↓ |
| RESULTING SIGNAL IS TRANSMITTED | 912 |

## FIG. 4

### TRANSMITTER EMBODIMENT

1000

INFORMATION SIGNAL → ACCEPTANCE MODULE → MODULATED SIGNAL → HGEM → ELECTRO-MAGNETIC SIGNAL → TRANSMISSION MODULE (OPTIONAL) → TRANSMITTED SIGNAL

1002    1004    1010    1006    1012    1008    1014

## FIG. 5

### I/O MODULATION MODE

1702

FIRST INFORMATION
SIGNAL GENERATED BY A
FIRST SOURCE
} STEP 902

OSCILLATING SIGNAL
GENERATED BY LOCAL
OSCILLATOR
} STEP 904

SECOND INFORMATION
SIGNAL GENERATED BY
A SECOND SOURCE
} STEP 902

1710

1714

IN-PHASE (I) OSCILLATING
SIGNAL MODULATED BY
1ST INFO SIGNAL

1704

PHASE OF OSCILLATING
SIGNAL IS SHIFTED 90°
CREATING QUADRATURE-
PHASE SIGNAL
} SIMILAR TO STEP 904

1716

QUADRATURE-PHASE (O)
OSCILLATING SIGNAL
MODULATED BY 2ND
INFO SIGNAL

1712

STEP 906

1706

'I' MODULATED SIGNAL
HAS PHASE SHIFTED AS
A FUNCTION OF THE 1ST
INFO SIGNAL

1718 — 'Q' MODULATED SIGNAL
HAS PHASE SHIFTED AS
A FUNCTION OF THE
2ND INFO SIGNAL
} STEP 906

1708

'I' SIGNAL WITH
PERIODIC WAVEFORM IS
GENERATED
} STEP 908

1720 — 'Q' SIGNAL WITH
PERIODIC WAVEFORM IS
GENERATED

1722

'I' AND 'Q' SIGNALS ARE COMBINED
} STEP 908

1724

WAVEFORM HAS HARMONICS
AT FOURIER COMPONENT FREQUENCIES

1726

UNWANTED HARMONICS ARE FILTERED OUT

1728

RESULTING SIGNAL IS AT
THE DESIRED ELECTROMAGNETIC (EM) FREQUENCY
} STEP 910

1700

1730

EM SIGNAL IS PREPARED
FOR TRANSMISSION
} STEP 912

1732

EM SIGNAL IS TRANSMITTED

## FIG. 6

## FIG. 7

LOCAL
OSCILLATOR

2402

OSCILLATING
SIGNAL

2404

1806

## FIG. 8

IN-PHASE
OSCILLATING
SIGNAL

2502

PHASE
SHIFTER

2504

QUADRATURE-PHASE
OSCILLATING
SIGNAL

2506

1810

## FIG. 9

INFORMATION
SIGNAL

2602

PHASE
MODULATOR

2606

PHASE MODULATED
OSCILLATING
SIGNAL

2608

OSCILLATING
SIGNAL

2604

1804,1816

## FIG. 10A

BIAS SIGNAL 2806
2808
2802 2824
2822
MODULATED OSCILLATING SIGNAL
2804 2820
2816
SIGNAL WITH HARMONICALLY RICH WAVEFORM
2814
2810
1214,1410,1822,1828
A

## FIG. 10B

A
2812

## FIG. 10C

A
SECOND SIGNAL 2818

## FIG. 11A

BIAS
SIGNAL ⊸ ⌐2806

2802⌐ 2824⌐ ⌇

MODULATED
OSCILLATING
SIGNAL ⊸

2904⌐    S
         G    2901
2902⌐    D        2814 ⊸ SIGNAL WITH
                         HARMONICALLY
                         RICH WAVEFORM
2804

2906

(A)

## FIG. 11B

(A)

2812 ⌐ ⏚

## FIG. 11C

(A)

SECOND
SIGNAL    ⌐2818

## FIG. 12A

BIAS
SIGNAL
2806

2824

2814

SIGNAL WITH
HARMONICALLY
RICH WAVEFORM

3006   D   S   3008

G   G

MODULATED
OSCILLATING
SIGNAL   2804

3002   S   D   3004

3010   3012

A

## FIG. 12B

A

2812

## FIG. 12C

A

SECOND
SIGNAL   2818

35

## FIG. 13

HARMONICALLY RICH
'I' SIGNAL

~3404

1832

3402

SUMMER

HARMONICALLY RICH
'I/Q' SIGNAL

3408

HARMONICALLY RICH
'Q' SIGNAL

~3406

## FIG. 14

3504

HARMONICALLY RICH
SIGNAL

FILTER

HARMONIC SIGNAL AT
DESIRED FREQUENCY

3502

1836

3506

## FIG. 15

3602

-3db

BANDWIDTH
3604

865 900 915
MHz

DESIRED FREQUENCY

FIG. 16A

IN○——————●——————○OUT

FIG. 16B

IN○——||——●——⌇⌇⌇——○OUT

FIG. 17

HARMONIC SIGNAL
AT DESIRED
FREQUENCY

3804

TRANSMISSION
MODULE

TRANSMITTED
SIGNAL

3802

1840

## FIG. 18A

3902

3912

3906

3900

3910    3904

## FIG. 18B

WAVEFORM
3902

## FIG. 18C

WAVEFORM
3904

## FIG. 18D

WAVEFORM
3906

FIG. 19A

FIG. 19B

WAVEFORM
4002

FIG. 19C

WAVEFORM
4004

FIG. 19D

WAVEFORM
4006

## FIG. 20

4102    4120    4122    4124    4126

4104    4104    4104    4106    4104

4108    4110

## FIG. 21A

4102

## FIG. 21B

4120

## FIG. 21C

4124

## FIG. 21D

## FIG. 21E

4126

FIG. 22

## FIG. 23

CONTINUOUS
PERIODIC
WAVEFORM

HARMONIC
ENHANCEMENT
MODULE

STRING OF PULSES

4604

4602

4606

## FIG. 24

SIGNAL
REQUIRING
AMPLIFICATION

AMPLIFIER
MODULE

AMPLIFIED
SIGNAL

4704

4702

4706

# FIG. 25A

TRANSISTORS
MAY BE
2N5179

FIG. 25B

## FIG. 26

—6000

| τ/T = | 0.500 | 0.250 | 0.100 | 0.050 | 0.010 | 0.005 |
|---|---|---|---|---|---|---|
| HARMONIC | | | | | | |
| 1 | 0.6366 | 0.4502 | 0.1967 | 0.0996 | 0.0200 | 0.01000 |
| 2 | 0.00 | 0.3183 | 0.1871 | 0.0984 | 0.0200 | 0.01000 |
| 3 | 0.2122 | 0.1501 | 0.1717 | 0.0963 | 0.0200 | 0.01000 |
| 4 | 0.00 | 0.00 | 0.1514 | 0.0935 | 0.0199 | 0.00999 |
| 5 | 0.1273 | 0.0900 | 0.1273 | 0.0900 | 0.0199 | 0.00999 |
| 6 | 0.00 | 0.1061 | 0.1009 | 0.0858 | 0.0199 | 0.00999 |
| 7 | 0.0909 | 0.0643 | 0.0736 | 0.0810 | 0.0198 | 0.00998 |
| 8 | 0.00 | 0.00 | 0.0468 | 0.0757 | 0.0198 | 0.00997 |
| 9 | 0.0707 | 0.0500 | 0.0219 | 0.0699 | 0.0197 | 0.00997 |
| 10 | 0.00 | 0.0637 | 0.00 | 0.0637 | 0.0197 | 0.00996 |
| 11 | 0.0579 | 0.0409 | 0.0179 | 0.0572 | 0.0196 | 0.00995 |
| 12 | 0.00 | 0.00 | 0.0312 | 0.0505 | 0.0195 | 0.00994 |
| 13 | 0.0490 | 0.0346 | 0.0396 | 0.0436 | 0.0194 | 0.00993 |
| 14 | 0.00 | 0.0455 | 0.0432 | 0.0368 | 0.0194 | 0.00992 |
| 15 | 0.0424 | 0.0300 | 0.0424 | 0.0300 | 0.0193 | 0.00991 |
| 16 | 0.00 | 0.00 | 0.0378 | 0.0234 | 0.0192 | 0.00990 |
| 17 | 0.0374 | 0.0265 | 0.0303 | 0.0170 | 0.0191 | 0.00988 |
| 18 | 0.00 | 0.0354 | 0.0208 | 0.0109 | 0.0190 | 0.00987 |
| 19 | 0.0335 | 0.0237 | 0.0104 | 0.0052 | 0.0188 | 0.00985 |
| 20 | 0.00 | 0.00 | 0.00 | 0.00 | 0.0187 | 0.00984 |
| 21 | 0.0303 | 0.0214 | 0.0094 | 0.0047 | 0.0186 | 0.00982 |
| 22 | 0.00 | 0.0289 | 0.0170 | 0.0089 | 0.0184 | 0.00980 |
| 23 | 0.0277 | 0.0196 | 0.0224 | 0.0126 | 0.0183 | 0.00978 |
| 24 | 0.00 | 0.00 | 0.0252 | 0.0156 | 0.0182 | 0.00976 |
| 25 | 0.0255 | 0.0180 | 0.0255 | 0.0180 | 0.0180 | 0.00974 |
| 26 | 0.00 | 0.0245 | 0.0233 | 0.0198 | 0.0178 | 0.00972 |
| 27 | 0.0236 | 0.0167 | 0.0191 | 0.0210 | 0.0177 | 0.00970 |
| 28 | 0.00 | 0.00 | 0.0134 | 0.0216 | 0.0175 | 0.00968 |
| 29 | 0.0220 | 0.0155 | 0.0068 | 0.0217 | 0.0173 | 0.00966 |
| 30 | 0.00 | 0.0212 | 0.00 | 0.0212 | 0.0172 | 0.00963 |
| 31 | 0.0205 | 0.0145 | 0.0063 | 0.0203 | 0.0170 | 0.00961 |
| 32 | 0.00 | 0.00 | 0.0117 | 0.0189 | 0.0160 | 0.00958 |
| 33 | 0.0193 | 0.0136 | 0.0156 | 0.0172 | 0.0166 | 0.00956 |
| 34 | 0.00 | 0.0187 | 0.0178 | 0.0151 | 0.0164 | 0.00953 |
| 35 | 0.0182 | 0.0129 | 0.0182 | 0.0129 | 0.0162 | 0.00950 |
| 36 | 0.00 | 0.00 | 0.0168 | 0.0104 | 0.0160 | 0.00948 |
| 37 | 0.0172 | 0.0122 | 0.0139 | 0.0078 | 0.0158 | 0.00945 |
| 38 | 0.00 | 0.0168 | 0.0098 | 0.0052 | 0.0156 | 0.00942 |
| 39 | 0.0163 | 0.0115 | 0.0050 | 0.0026 | 0.0154 | 0.00939 |
| 40 | 0.00 | 0.00 | 0.00 | 0.00 | 0.0151 | 0.00935 |
| 41 | 0.0155 | 0.0110 | 0.0048 | 0.0024 | 0.0149 | 0.00932 |
| 42 | 0.00 | 0.0152 | 0.0089 | 0.0047 | 0.0147 | 0.00929 |
| 43 | 0.0148 | 0.0105 | 0.0120 | 0.0067 | 0.0144 | 0.00926 |
| 44 | 0.00 | 0.00 | 0.0138 | 0.0085 | 0.0142 | 0.00922 |
| 45 | 0.0141 | 0.0100 | 0.0141 | 0.0100 | 0.0140 | 0.00919 |
| 46 | 0.00 | 0.0130 | 0.0132 | 0.0112 | 0.0137 | 0.00915 |
| 47 | 0.0135 | 0.0096 | 0.0110 | 0.0121 | 0.0135 | 0.00912 |
| 48 | 0.00 | 0.00 | 0.0078 | 0.0126 | 0.0132 | 0.00908 |
| 49 | 0.0130 | 0.0092 | 0.0040 | 0.0128 | 0.0130 | 0.00904 |
| 50 | 0.00 | 0.0127 | 0.00 | 0.0127 | 0.0127 | 0.00900 |

**EP 1 300 938 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0548542 A1
- EP 0548542 A
- US 4320361 A